Europäisches Patentamt

European Patent Office

Office européen des brevets

(19)

(11) **EP 1 222 324 B1**

(12) **EUROPEAN PATENT SPECIFICATION**

(45) Date of publication and mention
of the grant of the patent:
**06.05.2004 Bulletin 2004/19**

(51) Int Cl.7: **C30B 15/00**, C30B 29/06

(21) Application number: **00963572.3**

(86) International application number:
**PCT/US2000/025525**

(22) Date of filing: **18.09.2000**

(87) International publication number:
**WO 2001/021861 (29.03.2001 Gazette 2001/13)**

(54) **CZOCHRALSKI PROCESS FOR GROWING SINGLE CRYSTAL SILICON BY CONTROLLING THE COOLING RATE**

CZOCHRALSKIVERFAHREN ZUR HERSTELLUNG SILIZIUM-EINKRISTALLE DURCH STEUERUNG DER ABKÜHLGESCHWINDIGKEIT

PROCEDE CZOCHRALSKI PERMETTANT DE PRODUIRE DU SILICIUM MONOCRISTALLIN PAR REGULATION DE LA VITESSE DE REFROIDISSEMENT

(84) Designated Contracting States:
**DE FR GB IT**

(30) Priority: **23.09.1999 US 155725 P**

(43) Date of publication of application:
**17.07.2002 Bulletin 2002/29**

(73) Proprietor: **MEMC Electronic Materials, Inc.
St. Peters, MO 63376 (US)**

(72) Inventors:
  • **MCCALLUM, Kirk D., MEMC Electronic Materials
    St. Peters, MO 63376 (US)**
  • **ALEXANDER, W., Brock,
    MEMC Electronic Materials,
    St. Peters, MO 63376 (US)**
  • **BANAN, Mohsen, MEMC Electronic Materials,
    St. Peters, MO 63376 (US)**
  • **FALSTER, Robert J., MEMC Electronic Materials,
    St. Peters, MO 63376 (US)**
  • **HOLZER, Joseph C., MEMC Electronic Materials,
    St. Peters, MO 63376 (US)**
  • **JOHNSON, Bayard K.,
    MEMC Electronic Materials,
    St. Peters, MO 63376 (US)**
  • **KIM, Chang B., MEMC Electronic Materials,
    St. Peters, MO 63376 (US)**
  • **KIMBEL, Steven L., MEMC Electronic Materials,
    St. Peters, MO 63376 (US)**
  • **LU, Zheng, MEMC Electronic Materials,
    St. Peters, MO 63376 (US)**
  • **MUTTI, Paolo, MEMC Electronic Materials,
    St. Peters, MO 63376 (US)**
  • **VORONKOV, Vladimir V.,
    MEMC Electronic Materials,
    St. Peters, MO 63376 (US)**
  • **MULE'STAGNO, Luciano,
    MEMC Electronic Materials,
    St. Peters, MO 63376 (US)**
  • **LIBBERT, Jeffrey L., MEMC Electronic Materials,
    St. Peters, MO 63376 (US)**

(74) Representative: **Maiwald Patentanwalts GmbH
Elisenhof,
Elisenstrasse 3
80335 München (DE)**

(56) References cited:
**EP-A- 0 785 298        EP-A- 0 890 662
WO-A-98/45508           US-A- 5 840 120
US-A- 5 919 302**

## EP 1 222 324 B1

**Description**

BACKGROUND OF THE INVENTION

The present invention generally relates to the preparation of semiconductor grade single crystal silicon which is used in the manufacture of electronic components. More particularly, the present invention relates to the preparation of single crystal silicon ingots and wafers having an axially symmetric region of vacancy or interstitial dominated material which is devoid of agglomerated intrinsic point defects, and a process for the preparation thereof.

Single crystal silicon, which is the starting material for most processes for the fabrication of semiconductor electronic components, is commonly prepared by the so-called Czochralski ("Cz") method. In this method, polycrystalline silicon ("polysilicon") is charged to a crucible and melted, a seed crystal is brought into contact with the molten silicon and a single crystal is grown by slow extraction. After formation of a neck is complete, the diameter of the crystal is enlarged by decreasing the pulling rate and/or the melt temperature until the desired or target diameter is reached. The cylindrical main body of the crystal which has an approximately constant diameter is then grown by controlling the pull rate and the melt temperature while compensating for the decreasing melt level. Near the end of the growth process but before the crucible is emptied of molten silicon, the crystal diameter must be reduced gradually to form an end-cone. Typically, the end-cone is formed by increasing the crystal pull rate and heat supplied to the crucible. When the diameter becomes small enough, the crystal is then separated from the melt.

In recent years, it has been recognized that a number of defects in single crystal silicon form in the crystal growth chamber as the crystal cools after solidification. Such defects arise, in part, due to the presence of an excess (i.e. a concentration above the solubility limit) of intrinsic point defects, which are known as vacancies and self-interstitials. Silicon crystals grown from a melt are typically grown with an excess of one or the other type of intrinsic point defect, either crystal lattice vacancies ("V") or silicon self-interstitials ("I"). It has been suggested that the type and initial concentration of these point defects in the silicon are determined at the time of solidification and, if these concentrations reach a level of critical supersaturation in the system and the mobility of the point defects is sufficiently high, a reaction, or an agglomeration event, will likely occur. Agglomerated intrinsic point defects in silicon can severely impact the yield potential of the material in the production of complex and highly integrated circuits.

Vacancy-type defects are recognized to be the origin of such observable crystal defects as D-defects, Flow Pattern Defects (FPDs), Gate Oxide Integrity (GOI) Defects, Crystal Originated Particle (COP) Defects, crystal originated Light Point Defects (LPDs), as well as certain classes of bulk defects observed by infrared light scattering techniques such as Scanning Infrared Microscopy and Laser Scanning Tomography. Also present in regions of excess vacancies are defects which act as the nuclei for ring oxidation induced stacking faults (OISF). It is speculated that this particular defect is a high temperature nucleated oxygen agglomerate catalyzed by the presence of excess vacancies.

Defects relating to self-interstitials are less well studied. They are generally regarded as being low densities of interstitial-type dislocation loops or networks. Such defects are not responsible for gate oxide integrity failures, an important wafer performance criterion, but they are widely recognized to be the cause of other types of device failures usually associated with current leakage problems.

The density of such vacancy and self-interstitial agglomerated defects in Czochralski silicon is conventionally within the range of about $1*10^3/cm^3$ to about $1*10^7/cm^3$. While these values are relatively low, agglomerated intrinsic point defects are of rapidly increasing importance to device manufacturers and, in fact, are now seen as yield-limiting factors in device fabrication processes.

One approach which has been suggested to control the formation of agglomerated defects is to control the initial concentration of the point defects when the single crystal silicon is formed upon solidification from a molten silicon mass by controlling the pull rate (v) of the single crystal silicon ingot from the molten silicon mass and the axial temperature gradient, G, in the vicinity of the solid-liquid interface of the growing crystal. In particular, it has been suggested that the radial variation of the axial temperature gradient be no greater than 5 °C/cm. or less. See, e.g., Iida et al., EP0890662. This approach, however, requires rigorous design and control of the hot zone of a crystal puller.

Another approach which has been suggested to control the formation of agglomerated defects is to control the initial concentration of vacancy or interstitial point defects when the single crystal silicon is formed upon solidification from a molten silicon mass and controlling the cooling rate of the crystal from the temperature of solidification to a temperature of about 1,050 °C to permit the diffusion of silicon self-interstial atoms or vacancies and thereby maintain the supersaturation of the vacancy system or the interstitial system at values which are less than those at which agglomeration reactions occur. See, for example, Falster et al., U.S. Patent No. 5,919,302 and Falster et al., WO 98/45509. While these approaches may be successfully used to prepare single crystal silicon which is substantially free of agglomerated vacancy or interstitial defects, significant time may be required to allow for adequate diffusion of vacancies and interstitials. This may have the effect of reducing the throughput for the crystal puller.

## SUMMARY OF THE INVENTION

Among the several objects and features of the present invention may be noted the provision of a process for producing single crystal silicon which is substantially free of agglomerated intrinsic point defects which negatively impact the semiconductor properties of the silicon; the provision of such a process which does not substantially diminish the throughput of the crystal puller; the provision of such a process which substantially reduces the crystal puller from limitations on pull rate for production of the defect-free ingot; and the provision of such a process which substantial reduces the crystal puller from limitations on the average axial temperature gradient $G_o$.

Briefly, therefore, the present invention is directed to a process for growing a single crystal silicon ingot in which the ingot comprises a central axis, a seed-cone, an end-cone and a constant diameter portion between the seed-cone and the end-cone. The ingot is grown from a silicon melt in accordance with the Czochralski method, the process comprising cooling the ingot from the temperature of solidification to a temperature of less than 800 °C and, as part of said cooling step, quench cooling a region of the constant diameter portion of the ingot having a predominant intrinsic point defect through the temperature of nucleation for the agglomerated intrinsic point defects for the intrinsic point defects which predominate in the region.

The present invention is further directed to a process for growing a single crystal silicon ingot in which the ingot comprises a central axis, a seed-cone, an end-cone and a constant diameter portion between the seed-cone and the end-cone. The ingot is grown from a silicon melt in accordance with the Czochralski method, the process comprising forming a region comprising B-defects but not A-defects in the constant diameter portion of the ingot, the region having a width which is at least about 5% of the radial width of the constant diameter region of the ingot.

The present invention is further directed to a single crystal silicon wafer having a central axis, a front side and a back side which are generally perpendicular to the central axis, a circumferential edge, and a radius extending from the central axis to the circumferential edge of the wafer of at least about 62.5 mm. The wafer comprises an axially symmetric region having a width which is at least about 5% of the radius of the wafer in which silicon self-interstitial atoms are the predominant intrinsic point defect and which contains silicon self-interstitial type B defects but not silicon self-interstitial type A defects.

The present invention is further directed to a single crystal silicon ingot having a central axis, a seed-cone, an end-cone, and a constant diameter portion between the seed-cone and the end-cone, the constant diameter portion having a circumferential edge and a radius extending from the central axis to the circumferential edge of at least about 62.5 mm. The single crystal silicon ingot is characterized in that after the ingot is grown and cooled from the solidification temperature, the constant diameter portion includes an axially symmetric region in which silicon self-interstitial atoms are the predominant intrinsic point defect and the axially symmetric region contains silicon self-interstitial type B defects but not silicon self-interstitial type A defects.

Other objects and features of this invention will be in parlt apparent and in part pointed out hereinafter.

## BRIEF DESCRIPTION OF THE DRAWINGS

FIG. 1 is a graph which shows an example of how $\Delta G_I$, the change in free energy required for the formation of agglomerated interstitial defects, increases as the temperature, T, decreases, for a given initial concentration of self-interstitials, [I].

FIG. 2 is a longitudinal, cross-sectional view of a single crystal silicon ingot showing, in detail, an axially symmetric region of a constant diameter portion of the ingot.

FIG. 3 is a cross-sectional image of an ingot prepared as discussed in Example 1.

FIG. 4 is a cross-sectional image of an ingot prepared as discussed in Example 2.

FIG. 5 is a cross-sectional image of an ingot prepared as discussed in Example 3.

FIG. 6 is an image comparing a wafer having B-defects before being subjected to a heat-treatment of the present invention to a wafer having B-defects which was subjected to a heat-treatment of the present invention as discussed in Example 4.

FIG. 7 is a series of images of wafers prepared as discussed in Example 4.

FIG. 8 is a series of images of wafers prepared as discussed in Example 4.

FIG. 9 is a series of images of wafers prepared as discussed in Example 4.

## DETAILED DESCRIPTION OF THE PREFERRED EMBODIMENTS

In accordance with the present invention, it has been discovered that the reactions in which vacancies and silicon self-interstitial atoms react to produce agglomerated intrinsic point defects can be suppressed by rapidly cooling the single crystal silicon through the temperature of nucleation for these defects. Without being bound to any particular theory, it is believed that rapid cooling, sometimes referred to as quenching herein, prevents the reaction from progressing by freezing the reactants, i.e., the intrinsic point defects, in place.

In general, the change in system free energy available to drive the reaction in which agglomerated vacancy defects are formed from vacancy point defects or in which agglomerated interstitial defects are formed from self-interstitial atoms in single crystal silicon is governed by Equation (1) :

$$\Delta G_{V/I} = kT \ln \left( \frac{[V/I]}{[V/I]^{eq}} \right) \quad (1)$$

wherein
$\Delta G_{V/I}$ is the change in free energy for the reaction which forms agglomerated vacancy defects or the reaction which forms the interstitial defects, as applicable,
k is the Boltzmann constant,
T is the temperature in K,
[V/I] is the concentration of vacancies or interstitials, as applicable, at a point in space and time in the single crystal silicon, and
$[V/I]^{eq}$ is the equilibrium concentration of vacancies or interstitials, as applicable, at the same point in space and time at which [V/I] occurs and at the temperature, T.
According to this equation, for a given concentration of vacancies, [V], a decrease in the temperature, T, generally results in an increase in $\Delta G_V$ due to a sharp decrease in $[V]^{eq}$ with temperature. Similarly, for a given concentration of interstitials, [I], a decrease in the temperature, T, generally results in an increase in $\Delta G_I$ due to a sharp decrease in $[I]^{eq}$ with temperature.

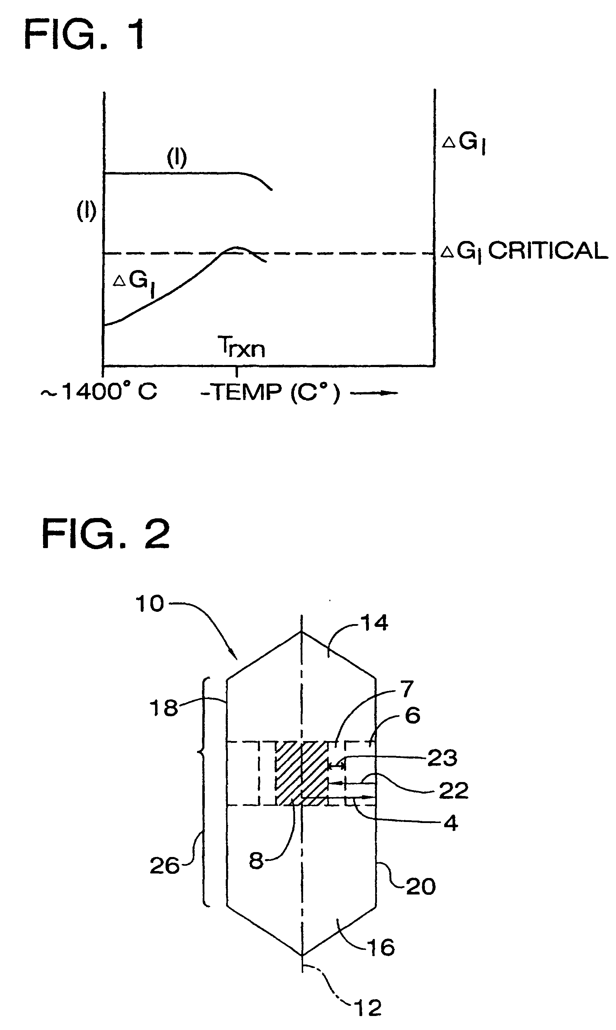

Fig. 1 schematically illustrates the change in $\Delta G_I$ and the concentration of silicon self-interstitials for an ingot which is slowly cooled (e.g., at a rate of about 2 °C/min. or less) from the temperature of solidification through the temperature at which agglomerated defects are nucleated without simultaneously employing some means for suppression of the concentration of silicon self-interstitials. As the ingot cools, $\Delta G_I$ increases according to Equation (1), due to the increasing supersaturation of [I], and the energy barrier for the formation of agglomerated interstitial defects is approached. As cooling continues, this energy barrier is eventually exceeded, at which point a reaction occurs. This reaction results in the formation of agglomerated interstitial defects and the concomitant decrease in $\Delta G_I$ as the supersaturated system is relaxed, i.e., as the concentration of [I] decreases.

Similarly, as an ingot is slowly cooled from the temperature of solidification without simultaneously employing some means for suppression of the concentration of vacancies, $\Delta G_V$ increases according to Equation (1), due to the increasing supersaturation of [V], and the energy barrier for the formation of agglomerated vacancy defects is approached. As cooling continues, this energy barrier is eventually exceeded, at which point a reaction occurs. This reaction results in the formation of agglomerated vacancy defects and the concomitant decrease in $\Delta G_V$ as the supersaturated system is relaxed.

Surprisingly, however, the reactions which produce agglomerated intrinsic point defects in Czochralski grown single crystal silicon ingots of commercially significant diameter can be suppressed by rapidly cooling the single crystal ingot at rates which are attainable without fracturing the ingot as a result of thermal stresses. Stated another way, agglomeration reactions which would occur if the single crystal silicon ingot were slowly cooled (e.g., a cooling rate of 2 °C or less) may be avoided by rapidly cooling the ingot through the nucleation temperature for agglomerated defects as the ingot is first cooled from the temperature of solidification to a temperature of no more than 800 °C. Rapid cooling appears to effectively increase the concentration of intrinsic point defects required for an agglomeration reaction to occur at a given temperature. Without being bound to any particular theory, it is presently believed that the concentration of intrinsic point defects in a rapidly cooled ingot may be supersaturated at the temperature at which agglomerated intrinsic point defects nucleate, but the kinetics of the reaction are slowed sufficiently that the reaction is never observed. Effectively, the reactants are frozen in place.

In general, the cooling rate required to avoid an agglomeration reaction increases with increasing concentrations of intrinsic point defects and, at least in theory, nucleation and growth of agglomerated intrinsic point defects can be avoided solely through the control of the cooling rate of the ingot through the nucleation temperature for agglomerated defects. As a practical matter, however, there is a limit to the rate at which a silicon ingot can be cooled without fracturing it and this limit sets a practical limit to the concentration of intrinsic point defects which may be present in the silicon ingot when it attains the nucleation temperature if an agglomeration reaction is to be avoided. In a preferred embodiment of the present invention, therefore, agglomeration reactions are suppressed by (i) controlling the concentration of intrinsic point defects in the single crystal silicon when it achieves the nucleation temperature, and (ii) controlling the cooling rate of the single crystal ingot as it passes through the nucleation temperature. In addition, the concentration of intrinsic point defects in the single crystal silicon as it approaches the nucleation temperature is preferably controlled by (i) controlling the initial concentration of intrinsic point defects in the single crystal ingot and (ii) allowing adequate time for diffusion of the intrinsic point defects to the surface of the silicon or for their annihilation (i. e., the combination of interstitials with vacancies) as the single crystal cools from the temperature of solidification to the temperature of nucleation.

Based upon experimental evidence to date, the type and initial concentration of intrinsic point defects appears to be initially determined as the ingot cools from the temperature of solidification (i.e., about 1410 °C) to a temperature greater than 1300 °C (i.e., at least about 1325 °C, at least about 1350 °C or even at least about 1375 °C). That is, the type and initial concentration of these defects are controlled by the ratio $v/G_0$, where v is the growth velocity and $G_0$ is the average axial temperature gradient over this temperature range.

The transition between vacancy and interstitial dominated material occurs at a critical value of $v/G_0$ which, based upon currently available information, appears to be about $2.1 \times 10^{-5}$ cm$^2$/sK where $G_0$ is determined under conditions in which the axial temperature gradient is constant within the temperature range defined above. At this critical value, the resulting concentrations of these intrinsic point defects are equal. As the value of $v/G_0$ exceeds the critical value, the concentration of vacancies increases. Likewise, as the value of $v/G_0$ falls below the critical value, the concentration of self-interstitials increases.

In accordance with the present invention, initial growth conditions are selected to provide an ingot containing (i) vacancies as the predominant intrinsic point defect from center to edge, (ii) silicon self-interstitials as the predominant intrinsic point defect from center to edge, or (iii) a central core in which vacancies are the predominant intrinsic point defect surrounded by an axially symmetric region in which silicon self-interstitials are the predominant intrinsic point defect. In general, the growth velocity, v, and the average axial temperature gradient, $G_0$, are preferably controlled such that the ratio $v/G_0$ falls within the range of about 0.5 to about 2.5 times the critical value of $v/G_0$ (i.e., about $1 \times 10^{-5}$ cm$^2$/sK to about $5 \times 10^{-5}$ cm$^2$/sK based upon currently available information for the critical value of $v/G_0$). More preferably, the ratio $v/G_0$ will fall within the range of about 0.6 to about 1.5 times the critical value of $v/G_0$ (i.e., about $1.3 \times 10^{-5}$ cm$^2$/sK to about $3 \times 10^{-5}$ cm$^2$/sK based upon currently available information for the critical value of $v/G_0$). In some embodiments, the ratio $v/G_0$ preferably falls within the range of about 0.75 to about 1.25 times the critical value of $v/G_0$ (i.e., about $1.6 \times 10^{-5}$ cm$^2$/sK to about $2.1 \times 10^{-5}$ cm$^2$/sK based upon currently available information for the critical value of $v/G_0$).

Because rapid cooling enables a process which is more robust with respect to the suppression of agglomerated defects than are prior processes, the process of the present invention allows for significantly more process variability than do prior art processes. For example, during the growth of an ingot $G_0$ may change as parts become coated and inaccurate pull rate calibration and diameter fluctuations can lead to variations in the pull, all of which can lead to variations in $v/G_0$ as a function of ingot. Similarly, aging of puller parts can result in crystal to crystal variation for crystals grown in the same crystal puller even though identical growth conditions were intended. Thus, processes carried out in accordance with the present invention are capable of consistently producing silicon ingots which are substantially free of agglomerated defects even though $v/G_0$ may vary by as much as 10% or greater as a function of crystal length or from crystal to crystal.

Control of the average axial temperature gradient, $G_0$, may be achieved through the design of the "hot zone" of the crystal puller, i.e. the graphite (or other materials) that makes up the heater, insulation, heat and radiation shields, among other things. Although the design particulars may vary depending upon the make and model of the crystal puller, in general, $G_0$ may be controlled using any of the means currently known in the art for controlling heat transfer at the melt/solid interface, including reflectors, radiation shields, purge tubes, light pipes, and heaters. In general, radial variations in $G_0$ are minimized by positioning such an apparatus within about one crystal diameter above the melt/solid interface. $G_0$ can be controlled further by adjusting the position of the apparatus relative to the melt and crystal. This is accomplished either by adjusting the position of the apparatus in the hot zone, or by adjusting the position of the melt surface in the hot zone. In addition, when a heater is employed, $G_0$ may be further controlled by adjusting the power supplied to the heater.

After solidification, the concentration of intrinsic point defects in the crystal is preferably reduced by permitting diffusion of the intrinsic point defects, and to the extent applicable, mutual annihilation of point defects. In general, diffusion of the predominant intrinsic point defects to the lateral crystal surface will be the principal means for reduction if the ingot is vacancy or interstitial dominated from the center to the lateral surface of the ingot. If, however, the ingot contains a vacancy dominated core surrounded by an axially symmetric interstitial dominated region, the reduction will primarily be a combination of outward diffusion of interstitials to the surface and inward diffusion of interstitials to the vacancy dominated region where they are annihilated. The concentration of such intrinsic point defects may thus be suppressed to prevent an agglomeration event from occurring.

The amount of time allowed for diffusion of the intrinsic point defects to the surface of the silicon or for their annihilation (i.e., the combination of interstitials with vacancies) as the single crystal cools from the temperature of solidification to the temperature of nucleation is, in part, a function of the initial concentration of intrinsic point defects, and, in part, a function of the cooling rate through the nucleation temperature for agglomerated defects. For example, in the absence of a rapid cooling step, agglomerated defects can generally be avoided if the ingot is cooled from the solidification temperature to a temperature within about 50 °C, 25 °C, 15 °C or even 10 °C of the nucleation temperature over a period of (i) at least about 5 hours, preferably at least about 10 hours, and more preferably at least about 15 hours for 150 mm nominal diameter silicon crystals, (ii) at least about 5 hours, preferably at least about 10 hours, more preferably at least about 20 hours, still more preferably at least about 25 hours, and most preferably at least about 30 hours for 200 mm nominal diameter silicon crystals, (iii) at least about 20 hours, preferably at least about 40 hours, more preferably at least about 60 hours, and most preferably at least about 75 hours for silicon crystals having a nominal diameter of 300 mm or greater. Thus, for those regions of the ingot which will be rapidly cooled, the diffusion time allowed will typically be some fraction of this time with the fraction decreasing with increasing cooling rates whereas the diffusion time allowed for those regions which are not rapidly cooled will be as described above. Preferably, as a percentage of the constant diameter portion of the ingot which is free of agglomerated defects, the regions which are rapidly cooled constitute at least 25%, more preferably at least 50% and still more preferably at least about 75% thereof.

The temperature at which nucleation of agglomerated defects occurs under slow-cool conditions is dependant upon the concentration and type of predominant intrinsic point defects (vacancy or silicon self-interstitial). In general, the nucleation temperature increases with increasing concentration of intrinsic point defect. In addition, the range of nucleation temperatures for agglomerated vacancy-type defects is somewhat greater than the range of nucleation temperatures for agglomerated interstitial-type defects; stated another way, over the range of vacancy concentrations typically produced in Czochralski grown single crystal silicon the nucleation temperature for agglomerated vacancy defects is generally between about 1,000 °C and about 1,200 °C and typically between about 1,000 °C and about 1,100 °C whereas over the range of silicon self-interstitial concentrations typically produced in Czochralski grown single crystal silicon, the nucleation temperature for agglomerated interstitial defects is generally between about 850 °C and about 1,100 °C and typically between about 870 °C and about 970 °C.

In one embodiment of the present invention, therefore, the ingot is rapidly cooled over the entire range of temperatures at which the predominant intrinsic point defects nucleate to form agglomerated defects. In another embodiment, an estimate of the temperature at which nucleation of the predominant intrinsic point defects occurs is experimentally or otherwise determined and the ingot is rapidly cooled over a range of temperatures extending from temperatures of 10 °C, 15 °C, 25 °C, 50 °C or more in excess of the determined nucleation temperature to temperatures of 10 °C, 15 °C, 25 °C, 50 °C or more below than the determined nucleation temperature. For example, under certain conditions it has been experimentally determined that the nucleation temperature is typically about 1,050 °C for vacancy dominated silicon and about 920 °C for silicon self-interstitial dominated silicon; under these conditions, therefore, it is preferred that the ingot be rapidly cooled over the range of temperatures of 1,050 ± 10 °C, 1,050 ± 15 °C, 1,050 ± 25 °C, 1,050 ± 50 °C or more for silicon self-interstitial dominated silicon and that the ingot be rapidly cooled over the range of temperatures of 920 ± 10 °C, 920 ± 15 °C, 920 ± 25 °C, 920 ± 50 °C or more for silicon self-interstitial dominated silicon.

The temperature at which nucleation of the predominant intrinsic point defects occurs can be experimentally determined for a given crystal puller and process as follows. It is believed that silicon self-interstitials in a defined region of the ingot remain as point defects and do not nucleate to form agglomerated defects until that region passes through the section of the hot zone where the silicon reaches the temperature of nucleation. That is, under typical Czochralski growth conditions, the region is originally formed at the solid/liquid interface and has a temperature of approximately the melt temperature of silicon. As the region is pulled away from the melt during the growth of the remainder of the ingot the temperature of the region cools as it is pulled through the hot zone of the crystal puller. The hot zone of a particular crystal puller typically has a characteristic temperature profile, generally decreasing with increasing distances from the melt solid interface, such that at any given point in time, the region will be at a temperature approximately equal to the temperature of the section of the hot zone occupied by the region. Accordingly, the rate at which the region is pulled through the hot zone affects the rate at which the region cools. Accordingly, an abrupt change in the pull rate will cause an abrupt change in the cooling rate throughout the ingot. Significantly, the rate at which a particular region of the ingot passes through the temperature of nucleation affects both the size and density of agglomerated defects formed in the region. Thus, the region of the ingot which is passing through the nucleation temperature at the time the abrupt change is made, will exhibit an abrupt variation in the size and density of agglomerated intrinsic point defects, hereinafter referred to as a nucleation front. Because the nucleation front is formed at the time the pull rate is varied, the precise location of the nucleation front along the axis of the ingot can be compared to the position of the ingot and correspondingly the nucleation front within the hot zone at the time the abrupt change in pull rate was made and compared with the temperature profile of the hot zone to determine the temperature at which the nucleation of agglomerated intrinsic point defects occurs for the type and concentration of intrinsic point defects in the location of the nucleation front.

Thus, persons skilled in the art can grow a silicon ingot by the Czochralski method under process conditions designed to produce an ingot which is either vacancy rich or silicon self-interstitial rich, making abrupt changes in the pull rate and by noting the position of the ingot with respect to the temperature profile in the hot zone at the point in time in which the pull rate is changed, and observing the axial location of the nucleation front, an approximation can be made as to the temperature of nucleation, for the concentration of intrinsic point defects present along the nucleation front. Additionally, since the temperature and intrinsic point defect concentration varies radially along the nucleation front, the temperature and intrinsic point defect concentration can be determined at several points along the nucleation front and the temperature of nucleation can be plotted against the intrinsic point defect concentration to determine the temperature of nucleation as a function of intrinsic point defect concentration. The temperature of the silicon along the nucleation front can be determined using any thermal simulation method known in the art which is capable of estimating the temperature at any location within a Czochralski reactor, such as for example, the thermal simulation described in Virzi, "Computer Modeling of Heat Transfer in Czochralski Silicon Crystal Growth," Journal of Crystal Growth, vol. 112, p. 699 (1991). The concentration of silicon self-interstitials may be estimated along the nucleation front using any point defect simulation method known in the art which is capable of estimating the concentration of intrinsic point defects at any point in the ingot, such as for example, the point defect simulation described in Sinno et al., "Point Defect Dynamics and the Oxidation-Induced Stacking-Fault Ring in Czochralski-Grown Silicon Crystals," Journal of Electrochemical Society. vol. 145, p. 302 (1998). Finally, the temperature of nucleation verses intrinsic point defect concentration can be obtained for an expanded range of temperatures and concentration by growing additional ingots under varying growth parameters to produced ingots with increased or decreased initial concentrations of intrinsic point defects, and repeating the cooling experiment and analysis described above.

The single crystal silicon is preferably cooled through the nucleation temperature as rapidly as possible without fracturing the single crystal ingot. The cooling rate through this temperature is, therefore, preferably at least 5 °C/min., more preferably at least about 10 °C/min., more preferably at least about 15 °C/min., still more preferably at least about 20 °C/min., still more preferably at least about 30 °C/min., still more preferably at least about 40 °C/min., and still more preferably at least about 50 °C/min.

In general, the single crystal silicon may be cooled through the nucleation temperature for agglomerated intrinsic point defects by means of at least two alternative approaches. In the first approach, the entire ingot (or at least those portions which are desired to be free of agglomerated vacancy defects and A-defects) are maintained at a temperature in excess of the nucleation temperature until the ingot tail is completed; the ingot is then detached from the melt, the heat input to the hot zone is shut down, and the single crystal silicon is moved from the hot zone of the Czochralski reactor to a chamber separate from the hot zone, such as a crystal receiving or other cooling chamber to quench cool the entire crystal (or at least those portions which are desired to be free of agglomerated vacancy defects and A-defects). The cooling chamber may be jacketed with a heat exchanging device designed utilize a cooling medium, for example cooling water, to remove heat from the cooling chamber at a rate sufficient to cool the single crystal silicon ingot at the desired rate, without directly contacting the single crystal silicon to the cooling medium. Alternatively, or in addition to using cooling jacket, a pre-cooled gas such as, for example, helium may be used to continuously purge the crystal receiving or other cooling chamber to facilitate more rapid cooling. Methods for removing heat from a process vessel are well know in the art, such that persons skilled in the art could employ a variety of means for removing heat from the crystal receiving or other cooling chamber without requiring undue experimentation.

In a second approach, a portion, preferably a large portion, of the ingot is quenched during crystal growth. In this approach, the hot zone of the crystal puller is designed to (i) achieve a desired value (or range of values) for $v/G_0$ across the entire radius of the growing crystal, (ii) provide adequate diffusion of intrinsic point defects at temperatures intermediate of the temperature of solidification and the nucleation temperature for agglomerated intrinsic point defects, and (iii) quench cool the ingot through the nucleation temperature for agglomerated intrinsic point defects of the type which predominate in the grown crystal by applying a steep axial temperature gradient over a range of temperatures containing the nucleation temperature.

Regardless of approach, the ingot may optionally contain, in additionally to the rapidly cooled segment, at least one section (from center to circumferential edge) in which agglomeration reactions are avoided simply by controlling the initial concentration of intrinsic point defects and allowing adequate time for diffusion prior to reaching the nucleation temperature as described above. In general, it is preferred that the rapidly cooled section comprise at least about 25%, more preferably at least about 50%, still more preferably at least about 75% and, in some embodiments, at least about 90% of the constant diameter portion of the ingot.

After the silicon is rapidly cooled through the temperature of nucleation of agglomerated intrinsic point defects, the silicon may thereafter may be cooled to room temperature at any cooling rate which is commercially expedient. Below the nucleation temperature, no further agglomeration reactions will take place.

In one embodiment of the present invention, the cooled ingot is free of agglomerated defects from center to circumferential edge for all or a substantial fraction of the constant diameter portion of the ingot. That is, the ingot is substantially free from all types of agglomerated vacancy and interstitial defects.

In another embodiment of the present invention, the cooled ingot may contain B-defects, a type of defect which forms in interstitial dominated material. While the precise nature and mechanism for the formation of B-defects is not known, it has become generally accepted that B-defects are agglomerations of silicon self-interstitials which are not dislocation loops. B-defects are smaller than A-defects (an agglomerated interstitial defect) and are generally thought not to be dislocation loops, but rather to be three dimensional agglomerations which have either not grown large enough or not reached a sufficient activation energy necessary to form dislocation loops. At this point, it is not yet clear that B-defects when present in an active electronic device region would negatively impact the performance of that device.

In any event, it has surprisingly been discovered that B-defects can be readily dissolved by slicing the ingot into wafers and heat-treating the wafers, provided the B-defects have not previously been stabilized. In one approach, therefore, wafers containing unstabilized B-defects are placed in a rapid thermal annealer and the wafer is rapidly heated to a target temperature (at which the B-defects begin to dissolve) and annealed at that temperature for a relatively short period of time. In general, the target temperature is preferably at least about 1050 °C, more preferably at least about 1100 °C, more preferably at least about 1150 °C, still more preferably at least about 1200 °C, and most preferably at least about 1250 °C. The wafer will generally be held at this temperature for a period of time which depends, in part, upon the target temperature with greater times being required for lesser temperatures. In general, however, the wafer will be held at the target temperature for at least several seconds (e.g., at least 3), preferably for several tens of seconds (e.g., 10, 20, 30, 40, or 50 seconds) and, depending upon the desired characteristics of the wafer and the target temperature, for a period which may range up to about 60 seconds (which is near the limit for commercially available rapid thermal annealers).

Heat-treatments at lesser temperatures for extended periods appear to stabilize B-defects. For example, annealing silicon containing B-defects at 900 °C for a period of four hours can stabilize the B-defects such that they are incapable of being dissolved by heat-treatments not in excess of about 1250 °C. Thus, the temperature of the wafer is ramped up to the target temperature relatively rapidly (e.g., at a rate of about 25 °C/sec.) to avoid stabilizing the defects; this can be accomplished in a rapid thermal annealer in a matter of seconds.

If desired, the heat-treatment can be carried out in a manner which enables the formation of a denuded zone in the near surface region of the wafer and micro defects in the bulk of the wafer. Such a process is carried out in a rapid thermal annealer and the wafers are rapidly heated to a target temperature and annealed at that temperature for a relatively short period of time. In general, the wafer is subjected to a temperature in excess of 1150 °C, preferably at least 1175 °C, more preferably at least about 1200 °C, and most preferably between about 1200 °C and 1275 °C. This rapid thermal annealing step may be carried out in the presence of a nitriding atmosphere or non-nitriding atmosphere. Nitriding atmospheres include nitrogen gas ($N_2$) or a nitrogen-containing compound gas such as ammonia which is capable of nitriding an exposed silicon surface. Suitable non-nitriding atmospheres include argon, helium, neon, carbon dioxide, and other such non-oxidizing, non-nitriding elemental and compound gases, or mixtures of such gases. The wafer will generally be maintained at this temperature for at least one second, typically for at least several seconds (e.g., at least 3), preferably for several tens of seconds (e.g., 20, 30, 40, or 50 seconds) and, depending upon the desired characteristics of the wafer, for a period which may range up to about 60 seconds (which is near the limit for commercially available rapid thermal annealers).

Upon completion of heat-treatment step, the wafer is rapidly cooled through the range of temperatures at which crystal lattice vacancies are relatively mobile in the single crystal silicon. In general, the average cooling rate within this range of temperatures is at least about 5 °C per second and preferably at least about 20 °C per second. Depending upon the desired depth of the denuded zone, the average cooling rate may preferably be at least about 50 °C per second, still more preferably at least about 100 °C per second, with cooling rates in the range of about 100 °C to about 200 °C per second being presently preferred for some applications. Once the wafer is cooled to a temperature outside the range of temperatures at which crystal lattice vacancies are relatively mobile in the single crystal silicon, the cooling rate does not appear to significantly influence the precipitating characteristics of the wafer and thus, does not appear to be narrowly critical.

Conveniently, the cooling step may be carried out in the same atmosphere in which the heating step is carried out. The ambient preferably has no more than a relatively small partial pressure of oxygen, water vapor, and other oxidizing gases. While the lower limit of oxidizing gas concentration has not been precisely determined, it has been demonstrated that for partial pressures of oxygen of 0.01 atmospheres (atm.), or 10,000 parts per million atomic (ppma), no increase in vacancy concentration and no effect is observed. Thus, it is preferred that the atmosphere have a partial pressure of oxygen and other oxidizing gases of less than 0.01 atm. (10,000 ppma); more preferably the partial pressure of these gases in the atmosphere is no more than about 0.005 atm. (5,000 ppma), more preferably no more than about 0.002 atm. (2,000 ppma), and most preferably no more than about 0.001 atm. (1,000 ppma).

The process of the present invention is primarily directed to the avoidance of agglomerated defects which are known to impact the yield potential of the silicon material in the production of complex and highly integrated circuits, such agglomerated defects including agglomerated vacancy defects (e.g., D-defects) and A-defects which cannot be readily dissolved throughout the silicon wafer by a heat-treatment of the type which may be used to dissolve B-defects. Because B-defects can be readily dissolved and may not be deleterious in any event, in one embodiment the process of the present invention includes the preparation of single crystal silicon which includes B-defects but is otherwise substantially free of agglomerated defects. In this instance, B-defects may be treated as if they are not an agglomerated intrinsic point defect. To the extent it is desired, however, that the single crystal silicon be substantially free of all agglomerated defects, including B-defects, the process includes the additional step of annealing wafers sliced from the B-defect containing ingot to eliminate them.

Referring now to Fig. 2, a single crystal silicon ingot 10 grown in accordance with the Czochralski method and the process of the present invention comprises a central axis 12, a seed-cone 14, an end-cone 16 and a constant diameter portion 18 between the seed-cone and the end-cone. The constant diameter portion has a circumferential edge 20 and a radius 4 extending from the central axis 12 to the circumferential edge 20. Preferably, radius 4 is at least 62.5 mm, more preferably at least about 75 mm, and still more preferably at least about 100 mm or even 150 mm.

In the embodiment of the present invention illustrated in Fig. 2, ingot 10 contains an axially symmetric region 6 in which silicon self-interstitials are the predominant intrinsic point defect surrounding a generally cylindrical region 8 in which vacancies are the predominant intrinsic point defect. The width of axially symmetric region 6 is measured from the circumferential edge radially toward the central axis of the ingot (along line 22), and the width of generally cylindrical region 8 is measured from the central axis radially toward the circumferential edge of the ingot. In one embodiment of the present invention, generally cylindrical region 8 is substantially free of agglomerated vacancy defects and axially symmetric region 6 is substantially free of type-A agglomerated interstitial defects.

In an alternative embodiment of the present invention, ingot 10 is interstitial dominated from center to edge; in this embodiment, the width of axial symmetric region 6 is equal to the radius 4 and the width of the generally cylindrical region 8 is zero. Similarly, when ingot 10 is vacancy dominated from center to edge in a third embodiment of the present invention, the width of generally cylindrical region 8 is equal to the radius and the width of axial symmetric region 6 is zero.

Referring again to Fig. 2, axially symmetric region 6 (when present) optionally includes axially symmetric region 7 which comprises B-type interstitial defects. As illustrated, the radially inward boundary of axially symmetric region 7 coincides with the radially inward boundary of axially symmetric region 6; the radially outward boundary of axially symmetric region 7, however, lies radially inward of circumferential edge 20. Thus, for example, if axially symmetric region 6 extends from central axis 12 to circumferential edge 20 (that is, the width of generally cylindrical region 8 is zero), axially symmetric region 7 will extend from central axis 12 to some boundary lying radially inward of circumferential edge 20.

Axially symmetric region 6 (when present) generally has a width, as measured from circumferential edge 20 radially inward toward central axis 12, of at least about 30%, and in some embodiments at least about 40%, at least about 60%, at least about 80% of the radius, or even 100% of the radius of the constant diameter portion of the ingot. In addition, axially symmetric region 6 (when present) generally extends over a length of at least about 20%, preferably at least about 40%, more preferably at least about 60%, and still more preferably at least about 80% of the length of the constant diameter portion of the ingot.

Similarly, axially symmetric region 7 (when present) generally has a width, as measured in the radial direction of at least about 1%, and in some embodiments at least about 5%, at least about 10%, at least about 25%, or even 50% of the radius of the constant diameter portion of the ingot. In addition, axially symmetric region 7 (when present) generally extends over a length of at least about 20%, preferably at least about 40%, more preferably at least about 60%, and still more preferably at least about 80% of the length of the constant diameter portion of the ingot.

The width of axially symmetric regions 6 and 7 may have some variation along the length of the central axis 12. As used herein, the width of axially symmetric regions 6 and 7 is considered to be the minimum width of each of those regions over a defined length of central axis 12. For example, for an axially symmetric region 6 of a given length the width of axially symmetric region 6 is determined by measuring the distance from the circumferential edge 20 of the ingot 10 radially toward a point which is farthest from the central axis. In other words, the width is measured such that the minimum distance within the given length of the axially symmetric region 6 is determined.

Substitutional carbon, when present as an impurity in single crystal silicon, has the ability to catalyze the formation of oxygen precipitate nucleation centers. For this and other reasons, therefore, it is preferred that the single crystal silicon ingot have a low concentration of carbon. That is, the concentration of carbon in the single crystal silicon is preferably less than about $5 \times 10^{16}$ atoms/cm$^3$, more preferably less than $1 \times 10^{16}$ atoms/cm$^3$, and still more preferably less than $5 \times 10^{15}$ atoms/cm$^3$.

It is to be noted that wafers which are sliced from ingots grown in accordance with the present invention are suitable for use as substrates upon which an epitaxial layer may be deposited. Epitaxial deposition may be performed by means common in the art.

Wafers which are sliced from ingots grown in accordance with the present invention are also suitable for use as substrates for semiconductor on insulator structures. The semiconductor on insulator composite may be formed, for example, as described in Iyer et al., U.S. Patent No. 5,494,849.

Furthermore, it is also to be noted that wafers prepared in accordance with the present invention are suitable for use in combination with hydrogen or argon annealing treatments, such as the treatments described in European Patent Application No. 503,816 A1.

Detection of Agglomerated Defects

Agglomerated defects may be detected by a number of different techniques. For example, flow pattern defects, or D-defects, are typically detected by preferentially etching the single crystal silicon sample in a Secco etch solution for about 30 minutes, and then subjecting the sample to microscopic inspection. (see, e.g., H. Yamagishi et al., Semicond. Sci. Technol. 7, A135 (1992)). Although standard for the detection of agglomerated vacancy defects, this process may also be used to detect A-defects. When this technique is used, such defects appear as large pits on the surface of the sample when present.

Additionally, agglomerated intrinsic point defects may be visually detected by decorating these defects with a metal capable of diffusing into the single crystal silicon matrix upon the application of heat. Specifically, single crystal silicon samples, such as wafers, slugs or slabs, may be visually inspected for the presence of such defects by first coating a surface of the sample with a composition containing a metal capable of decorating these defects, such as a concentrated solution of copper nitrate. The coated sample is then heated to a temperature between about 900°C and about 1000°C for about 5 minutes to about 15 minutes in order to diffuse the metal into the sample. The heat treated sample is then cooled to room temperature, thus causing the metal to become critically supersaturated and precipitate at sites within the sample matrix at which defects are present.

After cooling, the sample is first subjected to a non-defect delineating etch, in order to remove surface residue and precipitants, by treating the sample with a bright etch solution for about 8 to about 12 minutes. A typical bright etch solution comprises about 55 percent nitric acid (70% solution by weight), about 20 percent hydrofluoric acid (49% solution by weight), and about 25 percent hydrochloric acid (concentrated solution).

The sample is then rinsed with deionized water and subjected to a second etching step by immersing the sample in, or treating it with, a Secco or Wright etch solution for about 35 to about 55 minutes. Typically, the sample will be etched using a Secco etch solution comprising about a 1:2 ratio of 0.15 M potassium dichromate and hydrofluoric acid (49% solution by weight). This etching step acts to reveal, or delineate, agglomerated defects which may be present.

In an alternative embodiment of this "defect decoration" process, the single crystal silicon sample is subjected to a thermal anneal prior to the application of the metal-containing composition. Typically, the sample is heated to a temperature ranging from about 850 °C to about 950 °C for about 3 hours to about 5 hours. This embodiment is particularly preferred for purposes of detecting B-type silicon self-interstitial agglomerated defects. Without being held to a particular theory, it is generally believed that this thermal treatment acts to stabilize and grow B-defects, such that they may be more easily decorated and detected.

Agglomerated vacancy defects may also be detected using laser scattering techniques, such as laser scattering tomography, which typically have a lower defect density detection limit that other etching techniques.

In general, regions of interstitial and vacancy dominated material free of agglomerated defects can be distinguished from each other and from material containing agglomerated defects by the copper decoration technique described above. Regions of defect-free interstitial dominated material contain no decorated features revealed by the etching whereas regions of defect-free vacancy dominated material (prior to a high-temperature oxygen nuclei dissolution treatment as described above) contain small etch pits due to copper decoration of the oxygen nuclei.

Definitions

As used herein, the following phrases or terms shall have the given meanings: "agglomerated intrinsic point defects" or simply "agglomerated defects" mean defects caused (i) by the reaction in which vacancies agglomerate to produce D-defects, flow pattern defects, gate oxide integrity defects, crystal originated particle defects, crystal originated light point defects, and other such vacancy related defects, or (ii) by the reaction in which self-interstitials agglomerate to produce A-defects, dislocation loops and networks, and other such self-interstitial related defects; "agglomerated interstitial defects" shall mean agglomerated intrinsic point defects .caused by the reaction in which silicon self-interstitial atoms agglomerate; "agglomerated vacancy defects" shall mean agglomerated vacancy point defects caused by the reaction in which crystal lattice vacancies agglomerate; "radius" means the distance measured from a central axis to a circumferential edge of a wafer or ingot; "substantially free of agglomerated intrinsic point defects" shall mean a concentration (or size) of agglomerated defects which is less than the detection limit of these defects, which is currently about $10^3$ defects/cm$^3$; "V/I boundary" means the position along the radius (or axis) of an ingot or wafer at which the material changes from vacancy dominated to self-interstitial dominated; and "vacancy dominated" and "self-interstitial dominated" mean material in which the intrinsic point defects are predominantly vacancies or self-interstitials, respectively.

Examples

As the following examples illustrate, the present invention affords a process for preparing a single crystal silicon ingot in which, as the ingot cools from the solidification temperature in accordance with the Czochralski method, the agglomeration of intrinsic point defects is reduced and/or prevented by cooling the silicon through the temperature of nucleation, i.e., the temperature at which the nucleation of A-defects occurs for a given concentration of silicon self-interstitials, at a rate sufficient to prevent the formation of A-defects.

The cooling rate can be approximated using the axial temperature profile data for the hot zone of the Czochralski crystal grower and the actual pull rate profile for a particular ingot, wherein the cooling rate can be determined by and is a function of the pull rate, V and the axial temperature gradient, $G_z$, wherein the cooling rate can be approximated as the multiplication product of V and $G_z$. Accordingly, increases in pull rate result in an increase in cooling rate. In other words, any arbitrary point along the axis of the ingot will cool as a function of the rate at which it is pulled through the temperature profile for the hot zone. Since the temperature in the hot zone decreases with increasing distance from the melt surface, increases in pull rate, i.e., the rate at which that point travels through a hot zone which is decreasing in temperature, results in an increase in the cooling rate.

The following examples demonstrate that silicon with a given concentration profile of silicon self-interstitials may be cooled through the temperature of nucleation at a rate sufficient to suppress the nucleation of A-defects. In Examples 1, 2 and 3, the ingots were grown under conditions to produce ingots having interstitials as the predominant intrinsic point defect from center to edge along the entire length of the constant diameter portion of each ingot and an initial interstitial concentration which was substantially uniform in the axial direction but which decreased in the radially outward direction.

Example 1

Determination of the Nucleation Temperature as a Function of Concentration

A single crystal silicon ingot (200 mm nominal diameter), was grown in accordance with the Czochralski method using a hot zone configuration, designed by means common in the art. The process conditions were controlled to produce an interstitial rich ingot, wherein the thermal history of the ingot was controlled such that only the initial portion of the ingot, approximately the first 150 mm was cooled through the nucleation temperature at a cooling rate of approximately 0.4 °C/min, while the main body of the ingot remained at temperatures above the temperature of nucleation for interstitial agglomeration until the tail was completed and removed from the melt. The pull rate was then increased in a step-wise fashion such that the remainder of the ingot was cooled through the nucleation temperature at a cooling rate of approximately 1.2 °C/min.

Once cooled to ambient conditions, the ingot was cut longitudinally along the central axis running parallel to the direction of growth, and then further divided into sections which were each about 2 mm in thickness. Using the copper decoration technique previously described, the longitudinal sections were then heated and intentionally contaminated with copper, the heating conditions being appropriate for the dissolution of a high concentration of copper interstitials. Following this heat treatment, the samples were then rapidly cooled, during which time the copper impurities either out-diffused or precipitated at sites where A-defects or agglomerated interstitial defects where present.

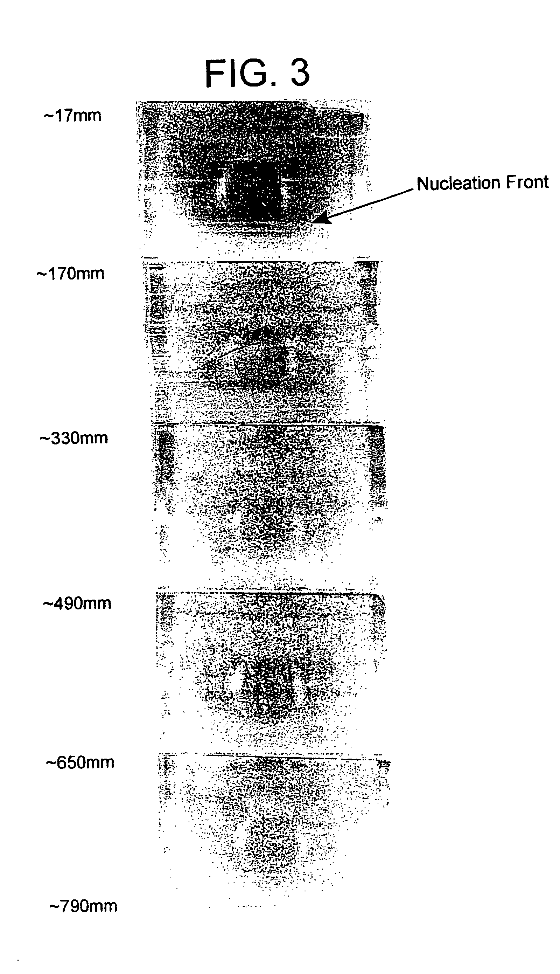

After a standard defect delineating etch, the samples were visually inspected for the presence of precipitated impurities, and digital images where made of each section of the ingot and pieced together forming a digital image of the axial cross section of the ingot as shown in Fig. 3. A-defects appear as white features or dots on the image. The dark circular feature appearing in approximately the center of each individual section is believed to be either an artifact remaining from the copper decoration process, or a reflection of the camera lens used to photograph the cross section of the ingot and is not indicative of any defect or deformation in the ingot.

Referring now to Fig. 3, there appears an abrupt variation in the number concentration of A-defects referred to hereinafter as a nucleation front which is approximately U-shaped such that the upper portions of the U-shaped nucleation front appear at approximately 100 mm along the axis of the ingot at the circumferential edge of the ingot, and the bottom of the U-shaped nucleation front appears at approximately 150 mm along the axis of the ingot at the core of the ingot. That is, the number density of the A-defects appearing above the nucleation front i.e. from 17 to 100 mm along the edge and from 17 to 150 along the core of the ingot is less than the number density of the A-defects appearing below the nucleation front i.e. from 100 to 1000 mm along the edge the ingot and from 150 to 1000 mm along the core of the ingot. This nucleation front represents the location along the axis of the ingot wherein silicon self-interstitial nucleation was occurring at the time cooling rate was increased, or in other words, the location along the axis of the ingot wherein the silicon was cooled through the temperature of nucleation at the time of the change in cooling rate. By noting the position of the ingot at the time of the change in cooling rate, and comparing the position of the ingot with the temperature profile in the hot zone of the reactor, the temperature of nucleation was estimated to occur within a temperature range of approximately 850 °C and 950 °C. The curvature of the nucleation front is due to the fact that both the temperature of the silicon ingot and the concentration of the silicon self-interstitials varies radially from the core of the ingot to the circumferential edge of the ingot.

Example 2

Reduction in A-defects by increasing the cooling rate through the temperature of nucleation

A single crystal silicon ingot (200 mm nominal diameter) was grown in accordance with the Czochralski method using a hot zone configuration, designed by means common in the art. The process conditions were controlled to produce a heavily interstitial rich ingot, wherein the thermal history of the ingot was controlled such that only the initial portion of the ingot, approximately the first 190 mm, was cooled through the nucleation temperature at a cooling rate of approximately 0.4 °C/min, while the main body of the ingot remained at temperatures above the temperature of nucleation for interstitial agglomeration until the tail was completed and removed from the melt, similar to the ingot described in Examples 1. The ingot was then held for approximately 30 hours (pull rate = 0 mm/min) after which the pull rate was increased in a step-wise fashion such that the section of the ingot ranging from approximately 190 to 360 mm/min along the axis of the ingot passed through the nucleation temperature at a cooling rate corresponding to about 1.2 °C/min. The pull rate was then further increased in a step-wise fashion such that the section of the ingot ranging from approximately 360 to 530 mm/min along the axis of the ingot passed through the nucleation temperature at a cooling rate corresponding to about 3.5 °C/min. The pull rate was then increased in a step-wise fashion such that the section of the ingot ranging from approximately 530 to 670 mm/min along the axis of the ingot passed through the nucleation temperature at a cooling rate corresponding to about 5.7 °C/min. Finally, the pull rate was decreased in a step-wise fashion such that the section of the ingot ranging from approximately 670 to 790 mm/min along the axis of the ingot passed through the nucleation temperature at a cooling rate corresponding to about 1.2 °C/min.

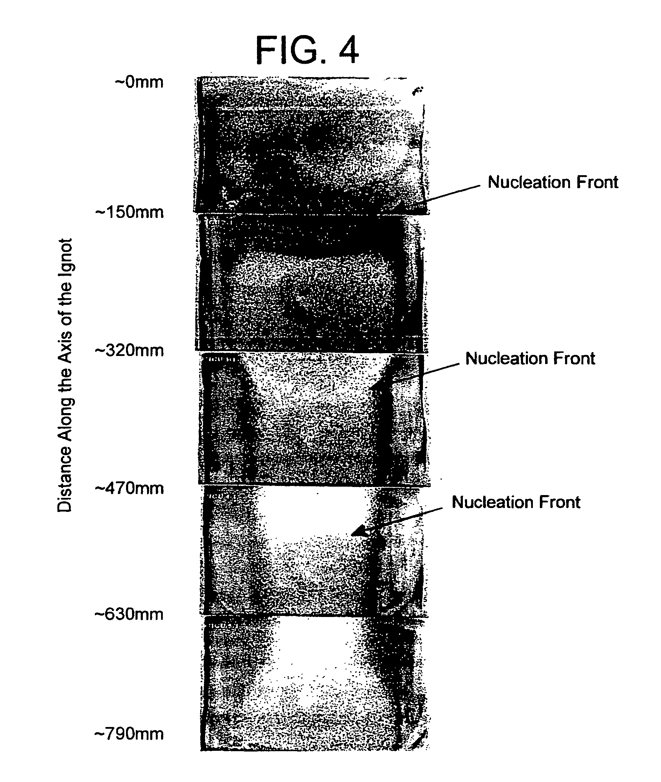

Once cooled to ambient conditions, the ingot was cut longitudinally along the central axis running parallel to the direction of growth, and then further divided into sections which were each about 2 mm in thickness. Using the copper decoration technique previously described, the longitudinal sections were then heated and intentionally contaminated with copper, the heating conditions being appropriate for the dissolution of a high concentration of copper interstitials. Following this heat treatment, the samples were then rapidly cooled, during which time the copper impurities either out-diffused or precipitated at sites where A-defects or agglomerated interstitial defects where present. After a standard defect delineating etch, the samples were visually inspected for the presence of precipitated impurities, and digital images where made of each section of the ingot and pieced together forming a digital image of the axial cross section of the ingot as shown in Fig. 4. A-defects appear as white features on the image. Similarly to examle 1, the dark circular feature appearing in approximately the center of each individual section is believed to be either an artifact remaining from the copper decoration process, or a reflection of the camera lense used to photograph the cross section of the ingot and is not indicative of any defect or deformation in the ingot.

Referring to Fig. 4, there appears a nucleation front ranging from approximately 100 to 190 mm along the axis of the ingot. This nucleation front represents the location along the axis of the ingot wherein silicon self-interstitial nucleation was occurring at the time the pull rate was increased from about 0 to about 1 mm/min. Additional nucleation fronts occur around 360 mm and 530 mm corresponding to locations along the axis of the ingot wherein the cooling rate through the temperature of nucleation was increased to about 3.5 °C/min and then increased to about 5.7 °C/min. Fig. 4 demonstrates the effect of cooling rate upon the number density and width of the region wherein silicon self-interstitials agglomerate. The region exhibiting A-defects becomes narrower with each successive increase in cooling rate showing that only the higher concentration of silicon self-interstitials at the core of the ingot continue to agglomerate. Moreover, as evidence that the cooling rate effects the diameter of the region at which agglomeration may occur, the region of the ingot corresponding to approximately 670 to 790 mm along the axis of the wafer which was cooled through the temperature of nucleation at a rate of °C/min. Not surprisingly, diameter of the area of A-defect formation is approximately equal to the diameter of the area of A-defect formation in the region ranging from approximately 190 to 360 mm along the axis of the ingot. Thus, as the cooling rate becomes increasingly higher, the process of the present invention is able to cool increasingly higher concentrations of silicon self-interstitials through the temperature of nucleation without generating a defects. In general, therefore, increasing the cooling rate through the temperature of nucleation allows for initially higher concentration of silicon self-interstitials to be present without agglomerating and forming A-defects, or alternatively results in a region wherein A-defects are formed, that decreases in diameter as the cooling rate is increased for a ingot having a fixed silicon self-interstitial concentration profile.

Example 3

Quench process for eliminating A-defects

A single crystal silicon ingot (200 mm nominal diameter) was grown in accordance with the Czochralski method using a hot zone configuration, designed by means common in the art. The process conditions were controlled to produce an interstitial rich ingot, wherein the thermal history of the ingot was controlled such that only the initial portion of the ingot, approximately the first 170 mm, was cooled through the nucleation temperature at a cooling rate of approximately 0.4 °C/min, while the main body of the ingot remained at temperatures above the temperature of nucleation for interstitial agglomeration until the tail was completed and removed from the melt, similar to the ingot described in Examples 1 and 2. The heater was then shut off, and the crystal was immediately removed from the hot zone such that the remainder of the ingot was cooled through the temperature of nucleation at a rate of approximately 27 °C/min.

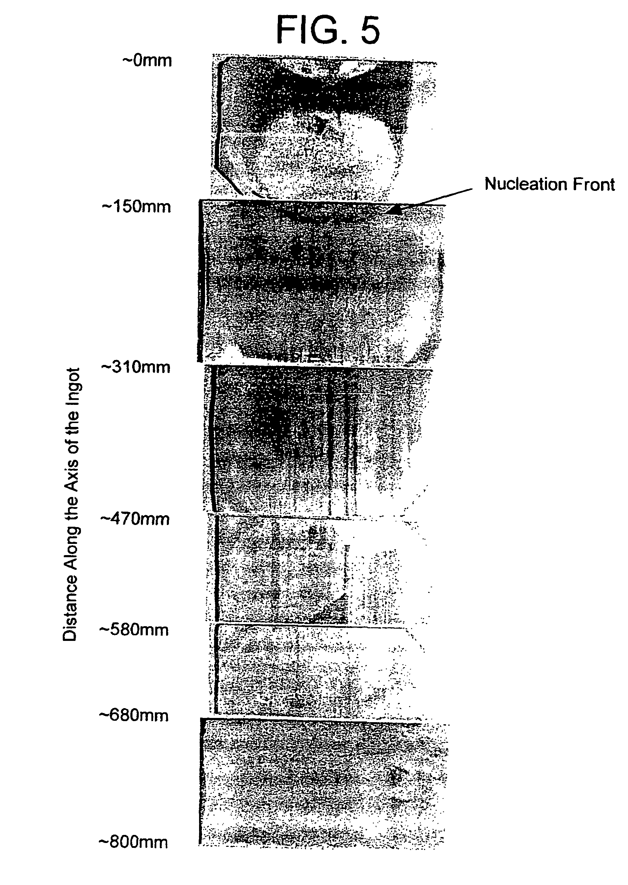

Once cooled to ambient conditions, the ingot was cut longitudinally along the central axis running parallel to the direction of growth, and then further divided into sections which were each about 2 mm in thickness. Using the copper decoration technique previously described, the longitudinal sections were then heated and intentionally contaminated with copper, the heating conditions being appropriate for the dissolution of a high concentration of copper interstitials. Following this heat treatment, the samples were then rapidly cooled, during which time the copper impurities either out-diffused or precipitated at sites where A-defects or agglomerated interstitial defects where present. After a standard defect delineating etch, the samples were visually inspected for the presence of precipitated impurities, and digital images where made of each section of the ingot and pieced together forming a digital image of the axial cross section of the ingot as shown in Fig. 5. A-defects appear as white features on the image.

Referring to Fig. 5, there appears a nucleation front ranging from approximately 110 to 370 mm along the axis of the ingot. This nucleation front represents the location along the axis of the ingot wherein silicon self-interstitial nucleation was occurring at the time the tail was completed and the ingot was pulled out of the hot zone such that the cooling rate was abruptly increased from about 0.4 °C/min to about 27 °C/min. The remainder of the ingot, which was cooled through the temperature of nucleation at a rate of approximately 27 °C/min is relatively free from A-defects, showing that when cooled sufficiently fast through the temperature of nucleation, A-defects do not form.

Example 4

Method for Annihilating B-Defects

A silicon single crystal ingot was pulled by the Czochralski method. The ingot was then sliced and polished to form silicon wafers. Wafers throughout a section of the crystal, which had received a 5 second, 950 °C rapid thermal process (hereinafter RTP) heat treatment were confirmed to contain B-defects using the B-defect delineating test discussed earlier.

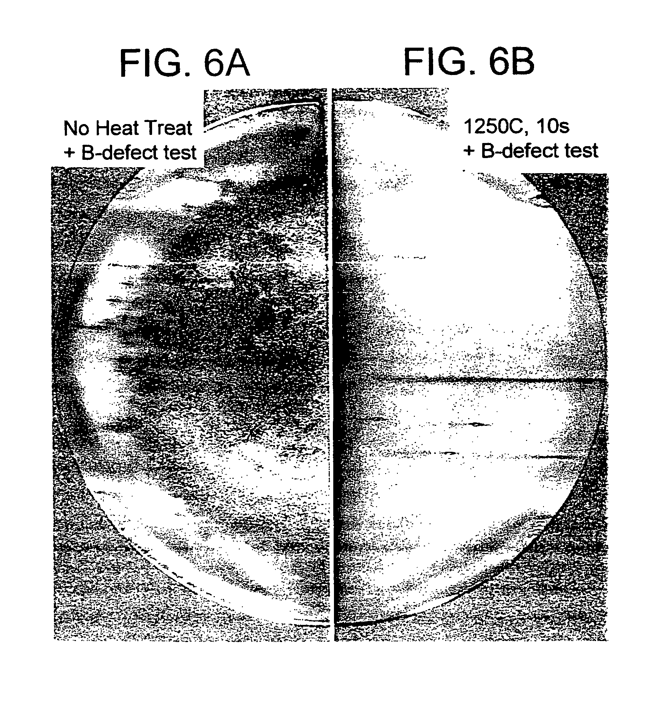

A wafer from the ingot was separated into two sections after which one section was subjected to a B-defect annihilation process, wherein the section was heated to a temperature of about 1250 °C at a rate of about 25 °C, and maintained at that temperature for a hold time of about 10s whereas the other section was not subjected to a B-defect annihilation process. Both sections were then treated with the B-defect delineating test discussed earlier and a digital image was taken of each delineated section. As shown in Figure 6, the wafer section subjected to the annihilation process (i.e. the section on the right in Figure 6) is substantially free of B-defects whereas the section of a wafer that was not subjected to the B-defect annihilation process (i.e., the section on the left in Figure 6) contains B-defects, which appear as white dots in the center of the wafer.

Additional wafers. wafers 1 through 10 in Table 1, from the same section of the crystal were then treated with various heat treatment processes wherein each wafer was heated at a rate of approximately 25 °C/min to a target temperature and for a specified period of time as described in Table 1.

Table 1

| Wafer No. | Heat Treatment Target Temperature (°C) / Hold Time(sec) | Ambient | Comment | B-defect Present(Y/N) |
|---|---|---|---|---|
| 1 | 1000/300 | Ar plus 500ppm $O_2$ | | Y |
| 2 | 1100/15 | Ar plus 500ppm $O_2$ | | Y |

Table 1  (continued)

| Wafer No. | Heat Treatment Target Temperature (°C) / Hold Time(sec) | Ambient | Comment | B-defect Present(Y/N) |
|---|---|---|---|---|
| 3 | 1100/60 | Ar plus 500ppm $O_2$ | | Y(very few) |
| 4 | 1250/10 | Ar plus 500ppm $O_2$ | 10C/s Rampdown | Indeterminate |
| 5 | 1150/60 | Ar plus 500ppm $O_2$ | | N |
| 6 | 1200/60 | Ar plus 500ppm $O_2$ | | N |
| 7 | 1175/60 | Ar plus 500ppm $O_2$ | | N |
| 8 | 1250/10 | Ar plus 500ppm $O_2$ | 5C/s Rampdown | N |
| 9 | 1250/10 | $O_2$ | 10C/s Rampdown | N |
| 10 | 1250/10 | $O_2$ | 10C/s Rampdown | N |

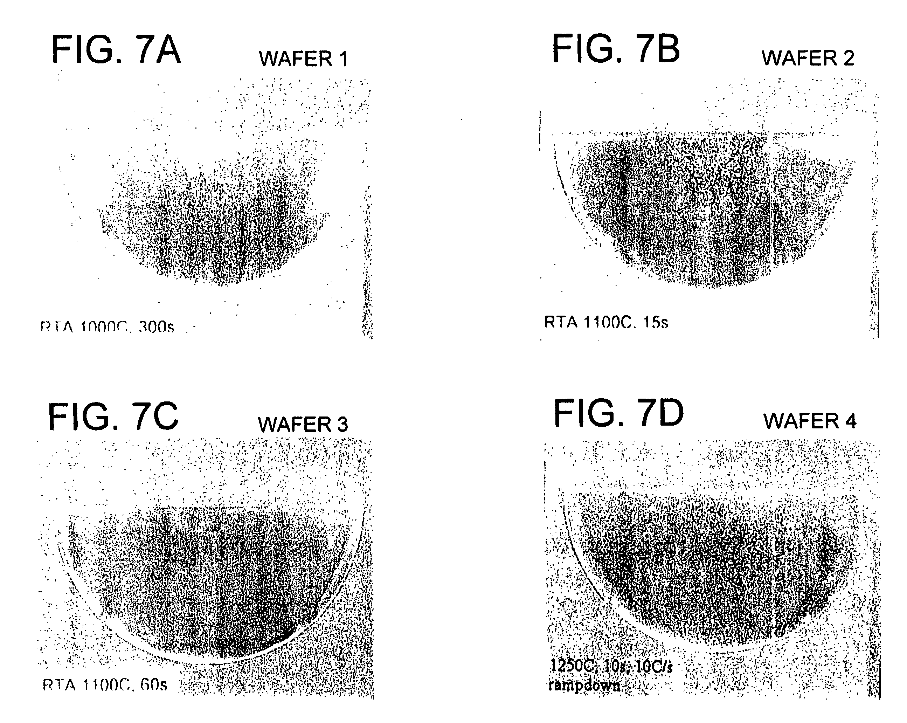

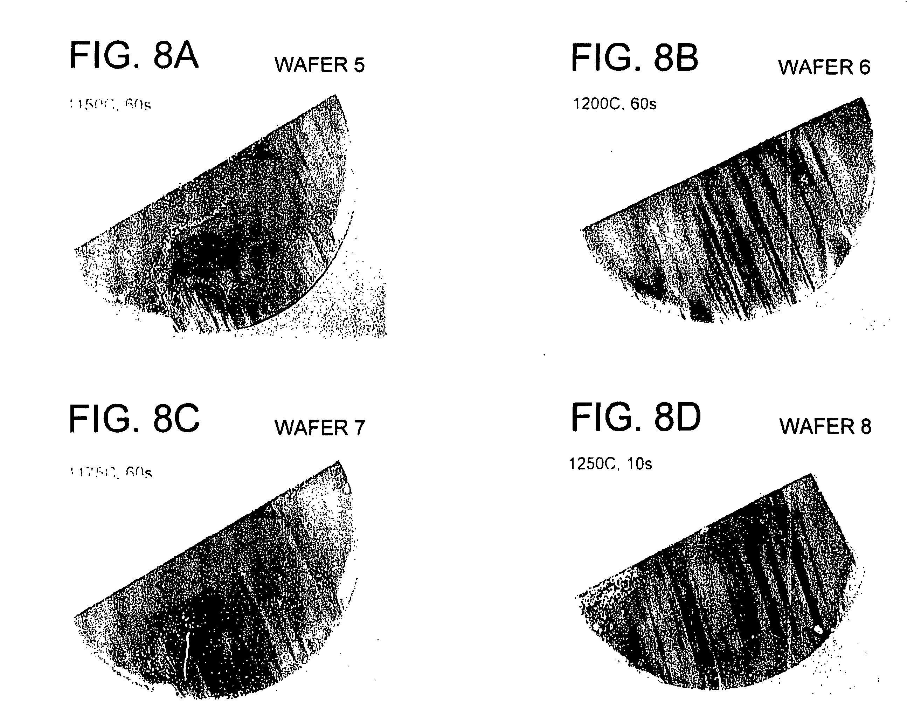

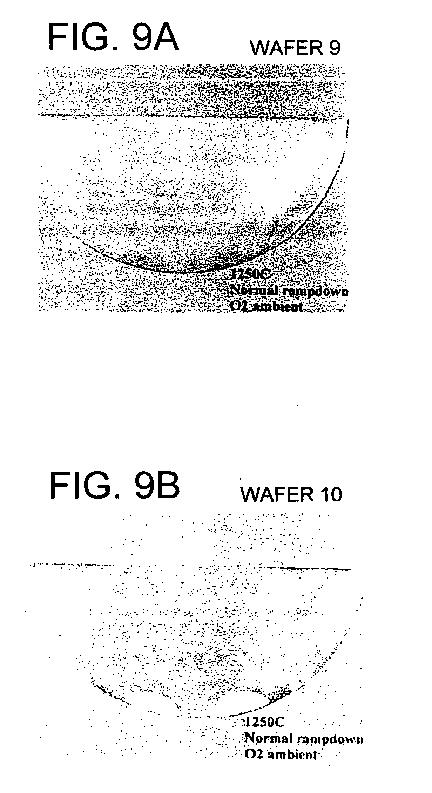

The wafers were then cooled to room temperature. Significantly, after being heated to a target temperature of 1000 °C for 5 minutes, wafer 1 shows a significant number of B-defects; when heated to 1100 °C for 15 seconds, wafer 2 shows considerably less B-defects; and when heated to 1100 °C for 60 seconds, wafer 3 shows almost no B-defects. (See Figure 7.) Thus, as demonstrated by wafers 1 through 3, as the target temperature is increased to above 1100 °C, the B-defects are significantly reduced, and given a sufficient hold time, are almost completely eliminated. Additionally, as shown in wafers 5 through 10, the B-defects may be annihilated when heated to temperatures above 1150, 1175, 1200 and 1250 and held for time periods ranging from about 10 to about 60 seconds. (See Table 1 and Figures 8 and 9.)

Wafer 4 was treated according to an ideal precipitating wafer process wherein the temperature was increased at a rate of about 25 °C/min, the target temperature was about 1250 °C, the hold time was about 10 seconds, and the cool down rate was about 10 °C/min. While wafer 4 shows a significant number of white dots when subjected to the copper decoration method as shown in Figure 7, it is believed that the ideal precipitation sites were decorated by the copper decoration method and appear as white dots, such that even though the B-defects were annihilated in the process, the image of wafer 4 still shows white dots across the surface of the wafer. To support this assumption, wafers 8 through 10 were subjected to the same temperature and hold time as wafer 4, however either the ambient or the cool down rate was varied such that the ideal precipitation sites were not formed. Wafers 8 through 10 show that B-defects are annihilated when a wafer is heated at a rate of about 25 °C/min to a temperature of about 1250 °C and held there for about 10 seconds, thus supporting the assumption that the white dots shown in wafer 4 are actually decorated ideal precipitation sites.

## Claims

1.  A process for growing a single crystal silicon ingot in which the ingot comprises a central axis, a seed-cone, an end-cone and a constant diameter portion between the seed-cone and the end-cone, the constant diameter portion having a circumferential edge and a radius extending from the central axis to the circumferential edge of at least 62.5 mm, the ingot being grown from a silicon melt in accordance with the Czochralski method, the process comprising cooling the ingot from the temperature of solidification to a temperature of less than 800 °C and, as part of said cooling step, quench cooling a region of the constant diameter portion of the ingot having a predominant intrinsic point defect through the temperature of nucleation for the agglomerated intrinsic point defects for the intrinsic point defects which predominate in the region.

2.  The process of claim 1 wherein the region has an axial length of at least 10% of the axial length of the constant diameter portion.

3. The process of claim 1 wherein the region has an axial length of at least 25% of the axial length of the constant diameter portion.

4. The process of claim 1 wherein the region has an axial length of at least 50% of the axial length of the constant diameter portion.

5. The process of claim 1 wherein the region has an axial length of at least 75% of the axial length of the constant diameter portion.

6. The process of claim 1 wherein the region has an axial length of at least 90% of the axial length of the constant diameter portion.

7. The process of claim 1 wherein the region has a width of at least 5% of the radius of the constant diameter portion.

8. The process of claim 7 wherein the region has an axial length of at least 10% of the axial length of the constant diameter portion.

9. The process of claim 7 wherein the region has an axial length of at least 25% of the axial length of the constant diameter portion.

10. The process of claim 7 wherein the region has an axial length of at least 50% of the axial length of the constant diameter portion.

11. The process of claim 7 wherein the region has an axial length of at least 75% of the axial length of the constant diameter portion.

12. The process of claim 1 wherein the region has a width of at least 10% of the radius of the constant diameter portion.

13. The process of claim 12 wherein the region has an axial length of at least 10% of the axial length of the constant diameter portion.

14. The process of claim 12 wherein the region has an axial length of at least 25% of the axial length of the constant diameter portion.

15. The process of claim 12 wherein the region has an axial length of at least 50% of the axial length of the constant diameter portion.

16. The process of claim 12 wherein the region has an axial length of at least 75% of the axial length of the constant diameter portion.

17. The process of claim 1 wherein the region has a width of at least 25% of the radius of the constant diameter portion.

18. The process of claim 1 wherein the region has a width of at least 50% of the radius of the constant diameter portion.

19. The process of claim 1 wherein the ingot is quench cooled through the range of temperatures from 1,200 °C to 1,000 °C.

20. The process of claim 19 wherein the region has a width of at least 5% of the radius of the constant diameter portion and has an axial length of at least 10% of the axial length of the constant diameter portion.

21. The process of any of claim 1 wherein the ingot is quench cooled through the range of temperatures from 1,100 °C to 1,000 °C.

22. The process of claim 21 wherein the region has a width of at least 10% of the radius of the constant diameter portion and has an axial length of at least 25% of the axial length of the constant diameter portion.

23. The process of any of claim 1 wherein the ingot is quench cooled through the range of temperatures from 850 °C to 1,100 °C.

24. The process of claim 23 wherein the region has a width of at least 5% of the radius of the constant diameter portion and has an axial length of at least 10% of the axial length of the constant diameter portion.

25. The process of any of claim 1 wherein the ingot is quench cooled through the range of temperatures from 870 °C to 970 °C.

26. The process of claim 25 wherein the region has a width of at least 10% of the radius of the constant diameter portion and has an axial length of at least 25% of the axial length of the constant diameter portion.

27. The process of claim 1 wherein the region is quench cooled at a rate of at least 5 °C/min.

28. The process of claim 1 wherein the region is quench cooled at a rate of at least 10 °C/min.

29. The process of claim 1 wherein the region is quench cooled at a rate of at least 20 °C/min.

30. The process of claim 1 wherein the region is quench cooled at a rate of at least 30 °C/min.

31. The process of claim 1 wherein the region is quench cooled at a rate of at least 40 °C/min.

32. The process of claim 1 wherein the region is quench cooled at a rate of at least 50 °C/min.

33. The process of claim 1 wherein the entire region is simultaneously quench cooled.

34. The process of claim 1 wherein after said cooling step the region contains B-defects but not A-defects.

35. The process of claim 1 wherein after said cooling step the ingot has a generally cylindrical region of vacancy dominated material which is substantially free of agglomerated vacancy defects.

36. The process of claim 1 wherein the constant diameter portion has a radius of at least 75 mm.

37. The process of claim 36 wherein the region has a width of at least 5% of the radius of the constant diameter portion and has an axial length of at least 10% of the axial length of the constant diameter portion.

38. The process of claim 36 wherein the region has a width of at least 10% of the radius of the constant diameter portion and has an axial length of at least 25% of the axial length of the constant diameter portion.

39. The process of claim 1 wherein the constant diameter portion has a radius of at least 100 mm.

40. The process of claim 39 wherein the region has a width of at least 5% of the radius of the constant diameter portion and has an axial length of at least 10% of the axial length of the constant diameter portion.

41. The process of claim 39 wherein the region has a width of at least 10% of the radius of the constant diameter portion and has an axial length of at least 25% of the axial length of the constant diameter portion.

42. The process of claim 1 wherein the constant diameter portion has a radius of at least 150 mm.

43. The process of claim 42 wherein the region has a width of at least 5% of the radius of the constant diameter portion and has an axial length of at least 10% of the axial length of the constant diameter portion.

44. The process of claim 42 wherein the region has a width of at least about 10% of the radius of the constant diameter portion and has an axial length of at least 25% of the axial length of the constant diameter portion.

45. A single crystal silicon wafer having a central axis, a front side and a back side which are generally perpendicular to the central axis, a circumferential edge, and a radius extending from the central axis to the circumferential edge of the wafer of at least 62.5 mm, the wafer comprising an axially symmetric region having a width of at least 5% of the radius, wherein silicon self-interstitial atoms are the predominant intrinsic point defect, the axially symmetric region containing silicon self-interstitial type B defects but not silicon self-interstitial type A defects.

46. The wafer of claim 45 wherein the region has a width of at least 10% of the radius of the wafer,

47. The wafer of claim 45 wherein the region has a width of at least 25% of the radius of the wafer.

48. The wafer of claim 45 wherein the wafer has a diameter of at least 200 mm.

49. A single crystal silicon ingot having a central axis, a seed-cone, an end-cone, and a constant diameter portion between the seed-cone and the end-cone having a circumferential edge and a radius extending from the central axis to the circumferential edge of at least 62.5 mm, the single crystal silicon ingot being **characterized in that** after the ingot is grown and cooled from the solidification temperature, the constant diameter portion includes an axially symmetric region having a width of at least 5% of the radius of the constant diameter portion, wherein silicon self-interstitial atoms are the predominant intrinsic point defect, the axially symmetric region containing silicon self-interstitial type B defects but not silicon self-interstitial type A defects.

50. The ingot of claim 49 wherein the region has a width of at least 10% of the radius of the constant diameter portion.

51. The ingot of claim 49 wherein the region has an axial length of at least 25% of the axial length of the constant diameter portion.

52. The ingot of claim 49 wherein the constant diameter portion has a diameter of at least 200 mm.

53. A single crystal silicon wafer having a central axis, a front side and a back side which are generally perpendicular to the central axis, a circumferential edge, and a radius extending from the central axis to the circumferential edge of the wafer of at least 62.5 mm, the wafer comprising an axially symmetric region substantially free of agglomerated intrinsic point defects, the region having a width of at least 25% of the radius and a concentration of intrinsic point defects greater than the saturation concentration for intrinsic point defects at a temperature of at least 800 °C.

54. The single crystal silicon wafer of claim 53 wherein the concentration of intrinsic point defects greater than the saturation concentration for intrinsic point defects at a temperature of at least 900 °C.

55. The single crystal silicon wafer of claim 53 wherein the concentration of intrinsic point defects greater than the saturation concentration for intrinsic point defects at a temperature of at least 1000 °C.

56. The single crystal silicon wafer of claim 53 wherein the concentration of intrinsic point defects greater than the saturation concentration for intrinsic point defects at a temperature of at least 1100 °C.

57. The single crystal silicon wafer of claim 53 wherein the region has a diameter of at least 50 % of the radius.

58. The single crystal silicon wafer of claim 53 wherein the region has a diameter of at least 75 % of the radius.

**Patentansprüche**

1. Verfahren zum Züchten eines Siliziumeinkristallrohlings, bei dem der Rohling eine zentrale Achse, einen Keimkegel, einen Endkegel und, zwischen dem Keimkegel und dem Endkegel, einen Teil mit einem konstanten Durchmesser umfasst, wobei der Teil mit dem konstanten Durchmesser eine Umgrenzungskante und einen Radius aufweist, der sich von der zentralen Achse bis zu der Umgrenzungskante erstreckt und mindestens 62,5 mm beträgt, wobei der Rohling aus einer Siliziumschmelze gemäß dem Czochralski-Verfahren gezüchtet wird und das Verfahren das Abkühlen des Rohlings von der Verfestigungstemperatur bis zu einer Temperatur von weniger als 800°C umfasst sowie, als Teil dieses besagten Abkühlungsschritts, das Abkühlen durch Abschrecken einer Region des Teil des Rohlings mit konstantem Durchmesser, die vorwiegend intrinsische Punktdefekte aufweist, mit der Temperatur der Keimbildung für agglomerierte intrinsische Punktdefekte für die intrinsischen Punktdefekte, die innerhalb der Region vorwiegend auftreten.

2. Verfahren gemäß Anspruch 1, wobei die Region eine axiale Länge von mindestens 10 % der axialen Länge des Teils mit konstantem Durchmesser hat.

3. Verfahren gemäß Anspruch 1, wobei die Region eine axiale Länge von mindestens 25 % der axialen Länge des Teils mit konstantem Durchmesser hat.

4. Verfahren gemäß Anspruch 1, wobei die Region eine axiale Länge von mindestens 50 % der axialen Länge des Teils mit konstantem Durchmesser hat.

5. Verfahren gemäß Anspruch 1, wobei die Region eine axiale Länge von mindestens 75 % der axialen Länge des Teils mit konstantem Durchmesser hat.

6. Verfahren gemäß Anspruch 1, wobei die Region eine axiale Länge von mindestens 90 % der axialen Länge des Teils mit konstantem Durchmesser hat.

7. Verfahren gemäß Anspruch 1, wobei die Region eine Breite von mindestens 5 % des Radius des Teils mit konstantem Durchmesser hat.

8. Verfahren gemäß Anspruch 7, wobei die Region eine axiale Länge von mindestens 10 % der axialen Länge des Teils mit konstantem Durchmesser hat.

9. Verfahren gemäß Anspruch 7, wobei die Region eine axiale Länge von mindestens 25 % der axialen Länge des Teils mit konstantem Durchmesser hat.

10. Verfahren gemäß Anspruch 7, wobei die Region eine axiale Länge von mindestens 50 % der axialen Länge des Teils mit konstantem Durchmesser hat.

11. Verfahren gemäß Anspruch 7, wobei die Region eine axiale Länge von mindestens 75 % der axialen Länge des Teils mit konstantem Durchmesser hat.

12. Verfahren gemäß Anspruch 1, wobei die Region eine Breite von mindestens 10 % des Radius des Teils mit konstantem Durchmesser hat.

13. Verfahren gemäß Anspruch 12, wobei die Region eine axiale Länge von mindestens 10 % der axialen Länge des Teils mit konstantem Durchmesser hat.

14. Verfahren gemäß Anspruch 12, wobei die Region eine axiale Länge von mindestens 25 % der axialen Länge des Teils mit konstantem Durchmesser hat.

15. Verfahren gemäß Anspruch 12, wobei die Region eine axiale Länge von mindestens 50 % der axialen Länge des Teils mit konstantem Durchmesser hat.

16. Verfahren gemäß Anspruch 12, wobei die Region eine axiale Länge von mindestens 75 % der axialen Länge des Teils mit konstantem Durchmesser hat.

17. Verfahren gemäß Anspruch 1, wobei die Region eine Breite von mindestens 25 % des Radius des Teils mit konstantem Durchmesser hat.

18. Verfahren gemäß Anspruch 1, wobei die Region eine Breite von mindestens 50 % des Radius des Teils mit konstantem Durchmesser hat.

19. Verfahren gemäß Anspruch 1, wobei der Rohling durch den Temperaturbereich von 1200°C bis 1000°C durch Abschrecken abgekühlt wird.

20. Verfahren gemäß Anspruch 19, wobei die Region eine Breite von mindestens 5 % des Radius des Teils mit konstantem Durchmesser und eine axiale Länge von mindestens 10 % der axialen Länge des Teils mit konstantem Durchmesser hat.

21. Verfahren gemäß Anspruch 1, wobei der Rohling durch den Temperaturbereich von 1100°C bis 1000°C durch Abschrecken abgekühlt wird.

22. Verfahren gemäß Anspruch 21, wobei die Region eine Breite von mindestens 10 % des Radius des Teils mit konstantem Durchmesser und eine axiale Länge von mindestens 25 % der axialen Länge des Teils mit konstantem Durchmesser hat.

23. Verfahren gemäß Anspruch 1, wobei der Rohling durch den Temperaturbereich von 850°C bis 1100°C durch Abschrecken abgekühlt wird.

24. Verfahren gemäß Anspruch 23, wobei die Region eine Breite von mindestens 5 % des Radius des Teils mit konstantem Durchmesser und eine axiale Länge von mindestens 10 % der axialen Länge des Teils mit konstantem Durchmesser hat.

25. Verfahren gemäß Anspruch 1, wobei der Rohling durch den Temperaturbereich von 870°C bis 970°C durch Abschrecken abgekühlt wird.

26. Verfahren gemäß Anspruch 25, wobei die Region eine Breite von mindestens 10 % des Radius des Teils mit konstantem Durchmesser und eine axiale Länge von mindestens 25 % der axialen Länge des Teils mit konstantem Durchmesser hat.

27. Verfahren gemäß Anspruch 1, wobei die Region mit einer Geschwindigkeit von mindestens 5°C/min durch Abschrecken abgekühlt wird.

28. Verfahren gemäß Anspruch 1, wobei die Region mit einer Geschwindigkeit von mindestens 10°C/min durch Abschrecken abgekühlt wird.

29. Verfahren gemäß Anspruch 1, wobei die Region mit einer Geschwindigkeit von mindestens 20°C/min durch Abschrecken abgekühlt wird.

30. Verfahren gemäß Anspruch 1, wobei die Region mit einer Geschwindigkeit von mindestens 30°C/min durch Abschrecken abgekühlt wird.

31. Verfahren gemäß Anspruch 1, wobei die Region mit einer Geschwindigkeit von mindestens 40°C/min durch Abschrecken abgekühlt wird.

32. Verfahren gemäß Anspruch 1, wobei die Region mit einer Geschwindigkeit von mindestens 50°C/min durch Abschrecken abgekühlt wird.

33. Verfahren gemäß Anspruch 1, wobei die gesamte Region gleichzeitig durch Abschrecken abgekühlt wird.

34. Verfahren gemäß Anspruch 1, wobei nach besagtem Abkühlungsschritt die Region B-Defekte, aber keine A-Defekte enthält.

35. Verfahren gemäß Anspruch 1, wobei nach besagtem Abkühlungsschritt der Rohling eine generell zylindrische Region mit Leerstellen-dominiertem Material aufweist, das im wesentlichen frei von agglomerierten Leerstellendefekten ist.

36. Verfahren gemäß Anspruch 1, wobei der Teil mit konstantem Durchmesser einen Radius von mindestens 75 mm hat.

37. Verfahren gemäß Anspruch 36, wobei die Region eine Breite von mindestens 5 % des Radius des Teils mit konstantem Durchmesser und eine axiale Länge von mindestens 10 % der axialen Länge des Teils mit konstantem Durchmesser hat.

38. Verfahren gemäß Anspruch 36, wobei die Region eine Breite von mindestens 10 % des Radius des Teils mit konstantem Durchmesser und eine axiale Länge von mindestens 25 % der axialen Länge des Teils mit konstantem Durchmesser hat.

**39.** Verfahren gemäß Anspruch 1, wobei der Teil mit konstantem Durchmesser einen Radius von mindestens 100 mm aufweist.

**40.** Verfahren gemäß Anspruch 39, wobei die Region eine Breite von mindestens 5 % des Radius des Teils mit konstantem Durchmesser und eine axiale Länge von mindestens 10 % der axialen Länge des Teils mit konstantem Durchmesser hat.

**41.** Verfahren gemäß Anspruch 39, wobei die Region eine Breite von mindestens 10 % des Radius des Teils mit konstantem Durchmesser und eine axiale Länge von mindestens 25 % der axialen Länge des Teils mit konstantem Durchmesser hat.

**42.** Verfahren gemäß Anspruch 1, wobei der Teil mit konstantem Durchmesser einen Radius von mindestens 150 mm aufweist.

**43.** Verfahren gemäß Anspruch 42, wobei die Region eine Breite von mindestens 5 % des Radius des Teils mit konstantem Durchmesser und eine axiale Länge von mindestens 10 % der axialen Länge des Teils mit konstantem Durchmesser hat.

**44.** Verfahren gemäß Anspruch 42, wobei die Region eine Breite von mindestens ca. 10 % des Radius des Teils mit konstantem Durchmesser und eine axiale Länge von mindestens 25 % der axialen Länge des Teils mit konstantem Durchmesser hat.

**45.** Ein Siliziumeinkristallwafer mit einer zentralen Achse, einer Vorderseite und einer Rückseite, die generell senkrecht zu der zentralen Achse sind, und einer Umgrenzungskante und einem Radius, der sich von der zentralen Achse zu der Umgrenzungskante des Wafers erstreckt und mindestens 62,5 mm beträgt, wobei der Wafer eine axialsymmetrische Region mit einer Breite von mindestens 5 % des Radius umfasst und wobei Silizium-Selbst-Zwischengitteratome die vorwiegenden intrinsischen Punktdefekte sind und die axialsymmetrische Region Silizium-Selbst-Zwischengitteratom-Typ B-Defekte, aber keine Silizium-Selbst-Zwischengitteratom-Typ A-Defekte aufweist.

**46.** Wafer gemäß Anspruch 45, wobei die Region eine Breite von mindestens 10 % des Radius des Wafers hat.

**47.** Wafer gemäß Anspruch 45, wobei die Region eine Breite von mindestens 25 % des Radius des Wafers hat.

**48.** Wafer gemäß Anspruch 45, wobei der Wafer einen Durchmesser von mindestens 200 mm hat.

**49.** Ein Siliziumeinkristallrohling mit einer zentralen Achse, einem Keimkegel, einem Endkegel und, zwischen dem Keimkegel und dem Endkegel, einem Teil mit konstantem Durchmesser, der eine Umgrenzungskante und einen Radius hat, der sich von der zentralen Achse zu der Umgrenzungskante erstreckt und mindestens 62,5 mm beträgt, wobei der Siliziumeinkristallrohling dadurch charakterisiert wird, dass, nachdem der Rohling gezüchtet und von der Verfestigungstemperatur abgekühlt worden ist, der Teil mit konstantem Durchmesser eine axialsymmetrische Region mit einer Breite von mindestens 5 % des Radius des Teils mit konstantem Durchmesser beinhaltet, wobei Silizium-Selbst-Zwischengitteratome die vorwiegenden intrinsischen Punktdefekte sind und die axialsymmetrische Region Silizium-Selbst-Zwischengitteratom-Typ B-Defekte, aber keine Silizium-Selbst-Zwischengitteratom-Typ A-Defekte enthält.

**50.** Rohling gemäß Anspruch 49, wobei die Region eine Breite von mindestens 10 % des Radius des Teils mit konstantem Durchmesser hat.

**51.** Rohling gemäß Anspruch 49, wobei die Region eine axiale Länge von mindestens 25 % der axialen Länge des Teils mit konstantem Durchmesser hat.

**52.** Rohling gemäß Anspruch 49, wobei der Teil mit konstantem Durchmesser einen Durchmesser von mindestens 200 mm hat.

**53.** Ein Siliziumeinkristallwafer mit einer zentralen Achse, einer Vorderseite und einer Rückseite, die generell senkrecht zu der zentralen Achsen sind, einer Umgebungskante und einem Radius, der sich von der zentralen Achse zu der Umgebungskante des Wafers erstreckt und mindestens 62,5 mm beträgt, wobei der Wafer eine axialsymmetrische Region, die im wesentlichen frei von agglomerierten intrinsischen Punktdefekten ist, umfasst und die Region eine Breite von mindestens 25 % des Radius und eine Konzentration an intrinsischen Punktdefekten aufweist, die größer als die Sättigungskonzentration für intrinsische Punktdefekte bei einer Temperatur von mindestens 800°C ist.

**54.** Siliziumeinkristallwafer gemäß Anspruch 53, wobei die Konzentration an intrinsischen Punktdefekten größer als die Sättigungskonzentration an intrinsischen Punktdefekte bei einer Temperatur von mindestens 900°C ist.

**55.** Siliziumeinkristallwafer gemäß Anspruch 53, wobei die Konzentration an intrinsischen Punktdefekten größer als die Sättigungskonzentration an intrinsischen Punktdefekten bei einer Temperatur von mindestens 1000°C ist.

**56.** Siliziumeinkristallwafer gemäß Anspruch 53, wobei die Konzentration an intrinsischen Punktdefekten größer als die Sättigungskonzentration an intrinsischen Punktdefekten bei einer Temperatur von mindestens 1100°C ist.

**57.** Siliziumeinkristallwafer gemäß Anspruch 53, wobei die Region einen Durchmesser von mindestens 50 % des Radius hat.

**58.** Siliziumeinkristallwafer gemäß Anspruch 53, wobei die Region einen Durchmesser von mindestens 75 % des Radius hat.

**Revendications**

**1.** Procédé pour la croissance d'un lingot de silicium monocristallin dans lequel le lingot comprend un axe central, un cône germe, un cône final et une partie à diamètre constant entre le cône-germe et le cône final, la partie à diamètre constant ayant un bord périphérique et un rayon disposé à partir de l'axe central vers le bord périphérique d'au moins 62,5 mm, la croissance du lingot s'effectuant à partir de silicium en fusion selon le procédé Czochralski, le procédé comprenant le refroidissement du lingot de la température de solidification à une température inférieure à 800°C et, dans le cadre de cette étape de refroidissement, le refroidissement par trempe d'une zone de la partie à diamètre constant du lingot ayant un défaut ponctuel intrinsèque prédominant à la température de nucléation pour les défauts ponctuels intrinsèques agglomérés pour les défauts ponctuels intrinsèques qui prédominent dans la zone.

**2.** Procédé selon la revendication 1 **caractérisé en ce que** la zone a une longueur axiale d'au moins 10 % de la longueur axiale de la partie à diamètre constant.

**3.** Procédé selon la revendication 1 **caractérisé en ce que** la zone a une longueur axiale d'au moins 25 % de la longueur axiale de la partie à diamètre constant.

**4.** Procédé selon la revendication 1 **caractérisé en ce que** la zone a une longueur axiale d'au moins 50 % de la longueur axiale de la partie à diamètre constant.

**5.** Procédé selon la revendication 1 **caractérisé en ce que** la zone a une longueur axiale d'au moins 75 % de la longueur axiale de la partie à diamètre constant.

**6.** Procédé selon la revendication 1 **caractérisé en ce que** la zone a une longueur axiale d'au moins 90 % de la longueur axiale de la partie à diamètre constant.

**7.** Procédé selon la revendication 1 **caractérisé en ce que** la zone a une largeur d'au moins 5 % du rayon de la partie à diamètre constant.

**8.** Procédé selon la revendication 7 **caractérisé en ce que** la zone a une longueur axiale d'au moins 10 % de la longueur axiale de la partie à diamètre constant.

**9.** Procédé selon la revendication 7 **caractérisé en ce que** la zone a une longueur axiale d'au moins 25 % de la longueur axiale de la partie à diamètre constant.

**10.** Procédé selon la revendication 7 **caractérisé en ce que** la zone a une longueur axiale d'au moins 50 % de la longueur axiale de la partie à diamètre constant.

**11.** Procédé selon la revendication 7 **caractérisé en ce que** la zone a une longueur axiale d'au moins 75 % de la longueur axiale de la partie à diamètre constant.

**12.** Procédé selon la revendication 1 **caractérisé en ce que** la zone a une largeur d'au moins 10 % du rayon de la partie à diamètre constant.

**13.** Procédé selon la revendication 12 **caractérisé en ce que** la zone a une longueur axiale d'au moins 10 % de la longueur axiale de la partie à diamètre constant.

**14.** Procédé selon la revendication 12 **caractérisé en ce que** la zone a une longueur axiale d'au moins 25 % de la longueur axiale de la partie à diamètre constant.

**15.** Procédé selon la revendication 12 **caractérisé en ce que** la zone a une longueur axiale d'au moins 50 % de la longueur axiale de la partie à diamètre constant.

**16.** Procédé selon la revendication 12 **caractérisé en ce que** la zone a une longueur axiale d'au moins 75 % de la longueur axiale de la partie à diamètre constant.

**17.** Procédé selon la revendication 1 **caractérisé en ce que** la zone a une largeur d'au moins 25 % du rayon de la partie à diamètre constant.

**18.** Procédé selon la revendication 1 **caractérisé en ce que** la zone a une largeur d'au moins 50 % du rayon de la partie à diamètre constant.

**19.** Procédé selon la revendication 1 **caractérisé en ce que** le lingot est refroidi par trempe dans la plage de température de 1.200°C à 1.000°C.

**20.** Procédé selon la revendication 19 **caractérisé en ce que** la zone a une largeur d'au moins 5 % du rayon de la partie à diamètre constant et a une longueur axiale d'au moins 10 % de la longueur axiale de la partie à diamètre constant.

**21.** Procédé selon l'une quelconque des formes de la revendication 1 **caractérisé en ce que** le lingot est refroidi par trempe dans la plage de température de 1.100°C à 1.000°C.

**22.** Procédé selon la revendication 21 **caractérisé en ce que** la zone a une largeur d'au moins 10 % du rayon de la partie à diamètre constant et a une longueur axiale d'au moins 25 % de la longueur axiale de la partie à diamètre constant.

**23.** Procédé selon l'une quelconque des formes de la revendication 1 **caractérisé en ce que** le lingot est refroidi par trempe dans la plage de température de 850°C à 1.100°C.

**24.** Procédé selon la revendication 23 **caractérisé en ce que** la zone a une largeur d'au moins 5 % du rayon de la partie à diamètre constant et a une longueur axiale d'au moins 10 % de la longueur axiale de la partie à diamètre constant.

**25.** Procédé selon l'une quelconque des formes de la revendication 1 **caractérisé en ce que** le lingot est refroidi par trempe dans la plage de température de 870°C à 970°C.

**26.** Procédé selon la revendication 25 **caractérisé en ce que** la zone a une largeur d'au moins 10 % du rayon de la partie à diamètre constant et a une longueur axiale d'au moins 25 % de la longueur axiale de la partie à diamètre constant.

**27.** Procédé selon la revendication 1 **caractérisé en ce que** la zone est refroidie par trempe à une vitesse d'au moins 5°C/mn.

**28.** Procédé selon la revendication 1 **caractérisé en ce que** la zone est refroidie par trempe à une vitesse d'au moins 10°C/mn.

**29.** Procédé selon la revendication 1 **caractérisé en ce que** la zone est refroidie par trempe à une vitesse d'au moins 20°C/mn.

**30.** Procédé selon la revendication 1 **caractérisé en ce que** la zone est refroidie par trempe à une vitesse d'au moins 30°C/mn.

**31.** Procédé selon la revendication 1 **caractérisé en ce que** la zone est refroidie par trempe à une vitesse d'au moins 40°C/mn.

**32.** Procédé selon la revendication 1 **caractérisé en ce que** la zone est refroidie par trempe à une vitesse d'au moins 50°C/mn.

**33.** Procédé selon la revendication 1 **caractérisé en ce que** toute la zone est refroidie simultanément par trempe.

**34.** Procédé selon la revendication 1 **caractérisé en ce que**, après ladite étape de refroidissement, la zone contient des défauts B mais pas de défauts A.

**35.** Procédé selon la revendication 1 **caractérisé en ce que**, après ladite étape de refroidissement, le lingot a une zone de matière dominée par les lacunes généralement cylindrique qui est sensiblement exempte de défauts de lacunes agglomérées.

**36.** Procédé selon la revendication 1 **caractérisé en ce que** la partie à diamètre constant a un rayon d'au moins 75 mm.

**37.** Procédé selon la revendication 36 **caractérisé en ce que** la zone a une largeur d'au moins 5 % du rayon de la partie à diamètre constant et a une longueur axiale d'au moins 10 % de la longueur axiale de la partie à diamètre constant.

**38.** Procédé selon la revendication 36 **caractérisé en ce que** la zone a une largeur d'au moins 10 % du rayon de la partie à diamètre constant et a une longueur axiale d'au moins 25 % de la longueur axiale de la partie à diamètre constant.

**39.** Procédé selon la revendication 1 **caractérisé en ce que** la partie à diamètre constant a un rayon d'au moins 100 mm.

**40.** Procédé selon la revendication 39 **caractérisé en ce que** la zone a une largeur d'au moins 5 % du rayon de la partie à diamètre constant et a une longueur axiale d'au moins 10 % de la longueur axiale de la partie à diamètre constant.

**41.** Procédé selon la revendication 39 **caractérisé en ce que** la zone a une largeur d'au moins 10 % du rayon de la partie à diamètre constant et a une longueur axiale d'au moins 25 % de la longueur axiale de la partie à diamètre constant.

**42.** Procédé selon la revendication 1 **caractérisé en ce que** la partie à diamètre constant a un rayon d'au moins 150 mm.

**43.** Procédé selon la revendication 42 **caractérisé en ce que** la zone a une largeur d'au moins 5 % du rayon de la partie à diamètre constant et a une longueur axiale d'au moins 10 % de la longueur axiale de la partie à diamètre constant.

**44.** Procédé selon la revendication 42 **caractérisé en ce que** la zone a une largeur d'au moins environ 10 % du rayon de la partie à diamètre constant et a une longueur axiale d'au moins 25 % de la longueur axiale de la partie à diamètre constant.

**45.** Lamelle de silicium monocristallin ayant un axe central, un côté avant et un côté arrière qui sont généralement perpendiculaires à l'axe central, un bord périphérique, et un rayon disposé à partir de l'axe central vers le bord périphérique de la lamelle d'au moins 62,5 mm, la lamelle comprenant une zone axialement symétrique ayant une largeur d'au moins 5 % du rayon, **caractérisée en ce que** les atomes auto-interstitiels de silicium sont le défaut ponctuel intrinsèque prédominant, la zone axialement symétrique contenant des défauts de type B auto-interstitiels de silicium mais pas de défauts de type A auto-interstiels de silicium.

46. Lamelle selon la revendication 45 **caractérisée en ce que** la zone a une largeur d'au moins 10 % du rayon de la lamelle.

47. Lamelle selon la revendication 45 **caractérisée en ce que** la zone a une largeur d'au moins 25 % du rayon de la lamelle.

48. Lamelle selon la revendication 45 **caractérisée en ce que** la lamelle a un diamètre d'au moins 200 mm.

49. Lingot de silicium monocristallin ayant un axe central, un cône-germe, un cône final et une partie à diamètre constant entre le cône-germe et le cône final ayant un bord périphérique et un rayon partant de l'axe central vers le bord périphérique d'au moins 62,5 mm, le lingot de silicium monocristallin étant **caractérisé en ce que** après la croissance du lingot et son refroidissement à partir de la température de solidification, la partie à diamètre constant comprend une zone axialement symétrique ayant une largeur d'au moins 5 % du rayon de la partie à diamètre constant, **caractérisé en ce que** les atomes auto-interstitiels de silicium sont le défaut ponctuel intrinsèque prédominant, la zone axialement symétrique contenant des défauts de type B auto-interstitiels de silicium mais pas des défauts de type A auto-interstitiels de silicium.

50. Lingot selon la revendication 49 **caractérisé en ce que** la zone a une largeur d'au moins 10 % du rayon de la partie à diamètre constant.

51. Lingot selon la revendication 49 **caractérisé en ce que** la zone a une longueur axiale d'au moins 25 % de la longueur axiale de la partie à diamètre constant.

52. Lingot selon la revendication 49 **caractérisé en ce que** la partie à diamètre constant a un diamètre d'au moins 200 mm.

53. Lamelle de silicium monocristallin ayant un axe central, un côté avant et un côté arrière qui sont généralement perpendiculaires à l'axe central, un bord périphérique, et un rayon disposé à partir de l'axe central vers le bord périphérique de la lamelle d'au moins 62,5 mm, la lamelle comprenant une zone axialement symétrique pratiquement exempte de défauts ponctuels intrinsèques agglomérés, la zone ayant une largeur d'au moins 25 % du rayon et une concentration des défauts ponctuels intrinsèques supérieure à la concentration de saturation pour les défauts ponctuels intrinsèques à une température d'au moins 800°C.

54. Lamelle de silicium monocristallin selon la revendication 53 **caractérisée en ce que** la concentration des défauts ponctuels intrinsèques est supérieure à la concentration de saturation pour les défauts ponctuels intrinsèques à une température d'au moins 900°C.

55. Lamelle de silicium monocristallin selon la revendication 53 **caractérisée en ce que** la concentration des défauts ponctuels intrinsèques est supérieure à la concentration de saturation pour les défauts ponctuels intrinsèques à une température d'au moins 1000°C.

56. Lamelle de silicium monocristallin selon la revendication 53 **caractérisée en ce que** la concentration des défauts ponctuels intrinsèques est supérieure à la concentration de saturation pour les défauts ponctuels intrinsèques à une température d'au moins 1100°C.

57. Lamelle de silicium monocristallin selon la revendication 53 **caractérisée en ce que** la zone a un diamètre d'au moins 50 % du rayon.

58. Lamelle de silicium monocristallin selon la revendication 53 **caractérisée en ce que** la zone a un diamètre d'au moins 75 % du rayon.

# FIG. 1

(l)

(l)

$\triangle G_l$

$\triangle G_l$ CRITICAL

$\triangle G_l$

$T_{rxn}$

~1400° C     -TEMP (C°) ──→

# FIG. 2

10    14
18    7
      6
      23
      22
26    4
8    20
      16
12

# FIG. 3

~17mm

Nucleation Front

~170mm

~330mm

~490mm

~650mm

~790mm

# FIG. 4

# FIG. 5

~0mm

~150mm

Nucleation Front

~310mm

~470mm

~580mm

~680mm

~800mm

Distance Along the Axis of the Ingot

28

## FIG. 6A

## FIG. 6B

No Heat Treat
+ B-defect test

1250C, 10s
+ B-defect test

FIG. 7A  WAFER 1  RTA 1000C, 300s

FIG. 7B  WAFER 2  RTA 1100C, 15s

FIG. 7C  WAFER 3  RTA 1100C, 60s

FIG. 7D  WAFER 4  1250C, 10s, 10C/s rampdown

FIG. 8A    WAFER 5

1150C, 60s

FIG. 8B    WAFER 6

1200C, 60s

FIG. 8C    WAFER 7

1175C, 60s

FIG. 8D    WAFER 8

1250C, 10s

# FIG. 9A     WAFER 9

1250C
Normal rampdown
O2 ambient

# FIG. 9B     WAFER 10

1250C
Normal rampdown
O2 ambient